# EUROPEAN PATENT SPECIFICATION

(11) **EP 3 273 492 B1**
(45) Date of publication and mention of the grant of the patent: **20.10.2021**
(21) Application number: 16765295.7
(22) Date of filing: 18.03.2016
(51) Int. Cl.: H01L 33/60, G03B 15/05

(54) **LIGHT-EMITTING DEVICE AND CAMERA MODULE HAVING SAME**
LICHTEMITTIERENDE VORRICHTUNG UND KAMERAMODUL DAMIT
DISPOSITIF ÉLECTROLUMINESCENT ET MODULE DE CAMÉRA LE COMPORTANT

(30) Priority: 18.03.2015 KR 20150037445
(43) Date of publication of application: 24.01.2018
(73) Proprietor: Suzhou Lekin Semiconductor Co., Ltd., Taicang City, Suzhou (CN)
(72) Inventor: KIM, Ki Hyun, Seoul 04637 (KR)
(74) Representative: Plasseraud IP
(86) International application number: PCT/KR2016/002766
(87) International publication number: WO 2016/148539

(56) References cited:
- JP-A- 2012 529 176
- JP-A- 2014 216 588
- KR-A- 20120 006 121
- KR-A- 20130 007 263
- KR-A- 20140 035 214
- US-A1- 2008 041 625
- US-A1- 2015 055 348

## Description

### TECHNICAL FIELD

Embodiments relate to a light-emitting device and a camera module having the same.

### BACKGROUND ART

Light-emitting devices, for example, light emitting diodes are a type of semiconductor devices that convert electrical energy into light and are being popularized as next-generation light sources in place of existing fluorescent and incandescent lamps.

Since light emitting diodes generate light by using semiconductor devices, the light emitting diodes consume very low power as compared with incandescent lamps that generate light by heating tungsten or fluorescent lamps that allow ultraviolet rays generated through a high pressure discharge to collide with a phosphor to generate light.

In recent years, kinds of portable devices with camera functions are increasing. Such a portable device includes a flash to provide an amount of light, which needs for capturing an image at night. In this regard, white light emitting diodes (LEDs) are increasing in use as light sources of camera flashes. Currently, there are two methods of using a light-emitting diode as a light source of a camera flash, i.e., a method using a reflector and an external cover having a reflective surface with high reflexibility, which is designed to match a radiation angle of the light-emitting diode with a view angle of a camera and a method in which a flash lens and a structure for fixing the flash lens are integrated with a light-emitting diode package.

The needs of the flash for the light-emitting diodes are increasing.

### DISCLOSURE OF THE INVENTION

### TECHNICAL PROBLEM

Embodiments provide a light-emitting device having a reflective frame opening a light-emitting chip on a body.

Embodiments also provide a light-emitting device in which an inclination of a corner region of a side surface of an opening portion of a reflective frame opening a light-emitting chip is greater than that in a different axial direction.

Embodiments also provide a camera module in which an illuminance in a diagonal direction is improved by light emitted through an opening portion of a reflective frame of a light-emitting device.

### TECHNICAL SOLUTION

A light-emitting device according to the invention is defined by claim 1.

A camera module according to the invention is defined by claim 15.

### ADVANTAGEOUS EFFECTS

In embodiments according to the invention, the illuminance of the edge portion of the target screen may be improved by the light emitted from the light-emitting device.

In embodiments according to the invention, the difference between the central illuminance of the screen and the illuminance in the outer region may be reduced by the light-emitting device.

In embodiments according to the invention, the light-emitting device and the camera module having the same may be improved in optical reliability.

### BRIEF DESCRIPTION OF THE DRAWINGS

FIG. 1 is a perspective view of a camera module according to an embodiment according to the invention.
FIG. 2 is a plan view illustrating a light-emitting device of the camera module of FIG. 1.
FIG. 3 is a perspective of the light-emitting device of FIG. 2.
FIG. 4 is a cross-sectional view taken along line A-A in the light-emitting device of FIG. 2.
FIG. 5 is a cross-sectional view taken along line B-B in the light-emitting device of FIG. 2.
FIG. 6 is a detailed view illustrating an opening portion of a reflective frame of the light-emitting device of FIG. 2.
FIGS. 7 and 8 are detailed plan views of the opening portion of FIG. 6.
FIG. 9 is a view of a screen in the camera module according to an embodiment according to the invention.
FIG. 10 is a view illustrating another example according to the invention of the light-emitting device of the camera module of FIG. 1.
FIG. 11 is a view illustrating another example according to the invention of the light-emitting device of the camera module of FIG. 1.
FIG. 12 is a side cross-sectional of the light-emitting device of FIG. 11.
FIG. 13 is a view illustrating a first example of a light-emitting chip of the light-emitting device according to an embodiment according to the invention.
FIG. 14 is a view illustrating a second example of the light-emitting chip of the light-emitting device according to an embodiment according to the invention.
FIG. 15 is a view illustrating a third example of the light-emitting chip of the light-emitting device according to an embodiment according to the invention.
FIG. 16A and 16B to 22A and 22B are views illustrating illuminance distribution and brightness at a center by samples of the light-emitting device according to an embodiment according to the invention.

### MODE FOR CARRYING OUT THE INVENTION

In the description of embodiments, it will be understood that when a layer (or film), region, pattern or structure is referred to as being 'on' or 'under' another layer (or film), region, pad or pattern, the terminology of 'on' and 'under' includes both the meanings of 'directly' and 'indirectly'. Further, the reference about 'on' and 'under' each layer or structure will be made on the basis of drawings.

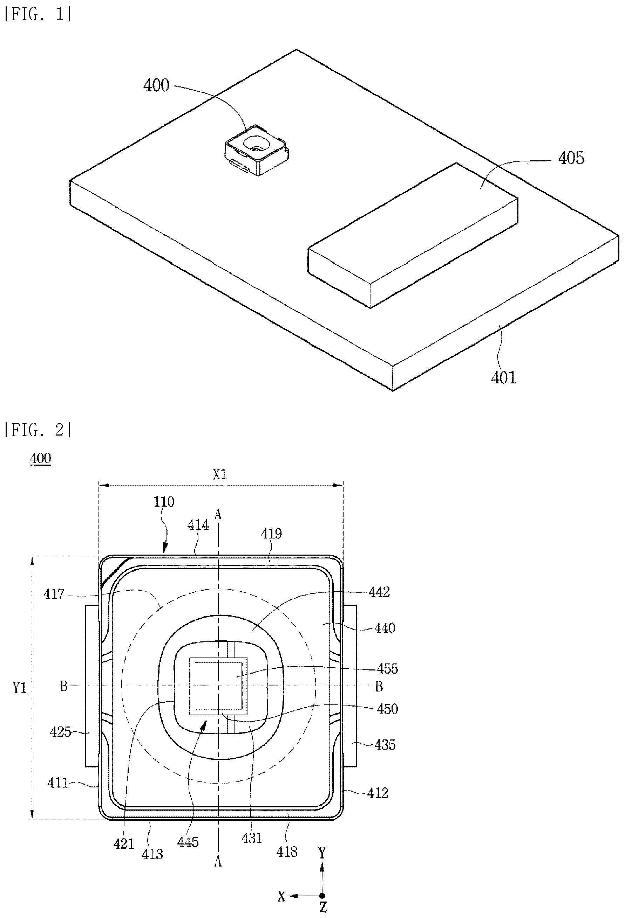

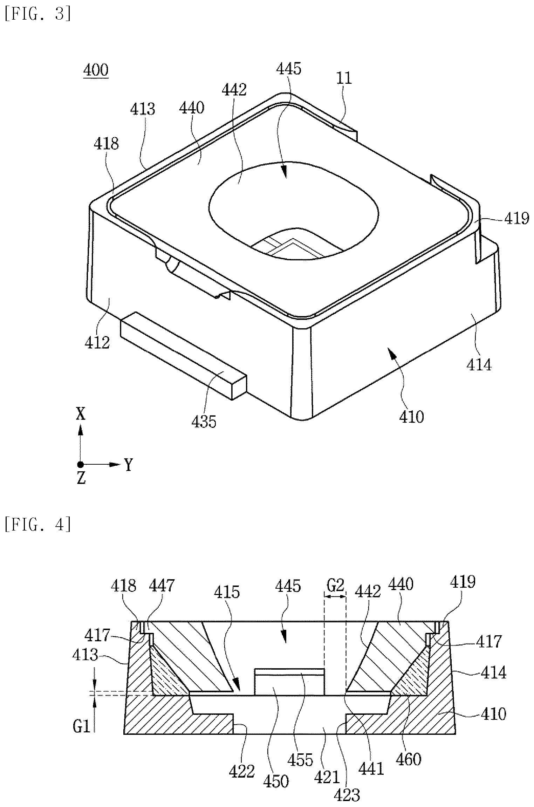

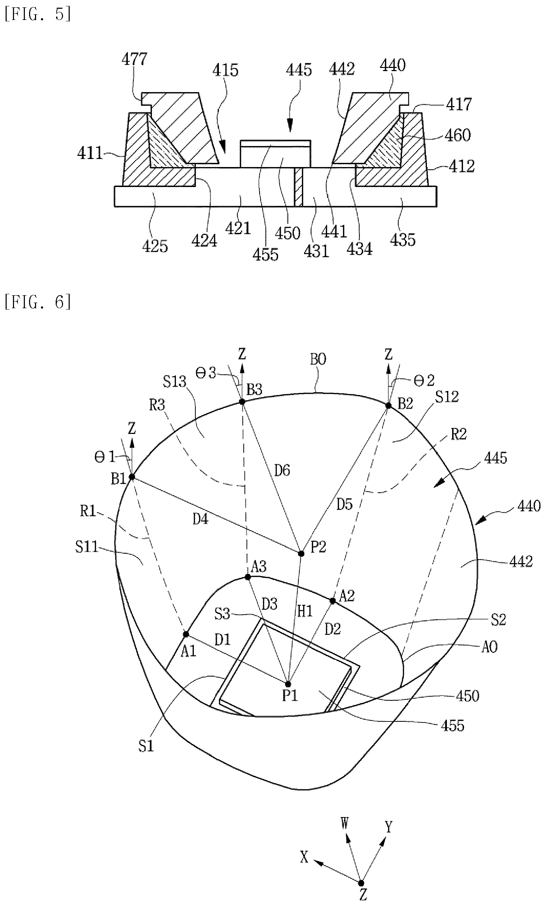

FIG. 1 is a perspective view of a camera module according to an embodiment according to the invention, FIG. 2 is a plan view illustrating a light-emitting device of the camera module of FIG. 1, FIG. 3 is a perspective of the light-emitting device of FIG. 2, FIG. 4 is a cross-sectional view taken along line A-A in the light-emitting device of FIG. 2, FIG. 5 is a cross-sectional view taken along line B-B in the light-emitting device of FIG. 2, FIG. 6 is a detailed view illustrating an opening portion of a reflective frame of the light-emitting device of FIG. 2, and FIGS. 7 and 8 are detailed plan views of the opening portion of FIG. 6.

Referring to FIGS. 1 to 9, a camera module includes a light-emitting device 400 and a camera 405, which are disposed on a circuit board 401, and the light-emitting device 400 is disposed adjacent to the camera 405 on the circuit board 401.

The circuit board 401 may include a PCB, a metal core PCB (MCPCB) or a flexible PCB (FPCB), which is made of a resin material, but is not limited thereto.

The light-emitting device 400 may be disposed on a circuit pattern of the circuit board 401 and electrically connected to the circuit board 401. An optical lens (not shown) may be coupled to the light-emitting device 400, but is not limited thereto. The optical lens may be coupled in a region of an opening portion (see reference numeral 445 of FIG. 2) of the light-emitting device 400 or disposed on the opening portion (see reference numeral 445 of FIG. 2).

The light-emitting device 400 may be mounted on the circuit board 401 in the form of a chip or mounted in the form of a package in which a chip is packaged. The light-emitting device according to an embodiment according to the invention will be described as an example of a light-emitting device that will be described below.

Referring to FIG. 2, the light-emitting device 400 includes a body 410, a plurality of lead frames 421 and 431 of which at least a portion is coupled to the body 410, a light-emitting chip 450 disposed on at least one of the plurality of lead frames 421 and 431, and a reflective frame 440 disposed on the body 410.

At least two lead frames 421 and 431 may be coupled to the body 410, and the light-emitting chip 450 may be disposed on the at least two lead frames 421 and 431.

The body 410 may be made of a material having reflectivity greater than a refractive index thereof, for example, a material having reflectivity of 70% or more with respect to a wavelength emitted by the light-emitting chip 450. The reflectivity of the body 410 is above 70%, the body 410 may be made of a non-transmissive material. The body 410 may be made of a resin-based insulation material, for example, a resin material such as of polyphthalamide (PPA). The body 410 may be made of a thermosetting resin including a silicon-based material, an epoxy-based material, or a plastic material, or a material having high heat resistance and high light resistance. The silicon-based body 410 is made of a white-based resin. Also, an acid anhydride, an antioxidant, a release agent, a light reflector, an inorganic filler, a curing catalyst, a light stabilizer, a lubricant, and titanium dioxide may be selectively added to the body 410. The body 410 may be molded by using at least one kind of material selected from the group consisting of an epoxy resin, a modified epoxy resin, a silicone resin, a modified silicone resin, an acrylic resin, and a urethane resin. For example, an epoxy resin composed of triglycidylisocyanurate, hydrogenated bisphenol A diglycidyl ether and the like, and an acid anhydride composed of hexahydrophthalic anhydride and 3-methylhexahydrophthalic anhydride, 4-methylhexahydrophthalic anhydride may be added to an epoxy resin by using DBU (1,8-Diazabicyclo (5,4,0) undecene-7) as a curing accelerator and ethylene glycol, titanium oxide pigment and glass fiber as a cocatalyst to partially cure the mixture through heating, and thereby to obtain a B-staged solidified epoxy resin composition for forming the body 410, but is not limited thereto. The body 410 may be formed by appropriately mixing at least one kind of material selected from the group consisting of a diffusing agent, a pigment, a fluorescent material, a reflective material, a light shielding material, a light stabilizer, and a lubricant with the thermosetting resin.

The body 410 may be made of a reflective material, for example, a resin material in which metal oxide is added to a resin material such as epoxy or silicone, and the metal oxide may include at least one of TiO₂, SiO₂, and Al₂O₃. The body 410 may effectively reflect incident light. For another example, the body 410 may be made of a transparent resin material or a resin material having a phosphor for converting a wavelength of incident light.

The body 410 may include a plurality of outer surfaces, for example, at least four side surfaces 411, 412, 413, and 414. At least one or all of the plurality of side surfaces 411, 412, 413, and 414 may be disposed to be tilted with respect to a bottom surface of the body 410 or horizontal bottom surfaces of the lead frames 421 and 431. Referring to the first to fourth side surfaces 411, 412, 413, and 414 of the body 410, the first side surface 411 and the second side surface 412 are disposed at opposite sides, and the third side surface 413 and the fourth side surface 414 are disposed at opposite sides. Each of the first side surface 411 and the second side surface 412 has a length Y1 equal to or different from a length XI of each of the third side surface 413 and the fourth side surface 414. For example, each of the first side surface 411 and the second side surface 412 may have a length Y1 equal to or greater than a length X1 of each of the third side surface 413 and the fourth side surface 414. Each of the first side surface 411 and the second side surface 412 may be defined as a long side surface having a length greater than that of each of the third and fourth side surfaces 413 and 414, and each of the third and fourth side surfaces 413 and 414 may be defined as a short side surface having a length less than that of each of the first and second side surfaces 411 and 412.

The length Y1 of the first side surface 411 or the second side surface 412 may be a distance between the third side surface 413 and the fourth side surface 414.

An edge portion that is a boundary between the first to fourth side surfaces 411, 412, 413, and 414 may have an angled surface or curved surface, but is not limited thereto. The length of the body 410 may be a length in a first axis (X) direction and also a length of each of the short side surfaces that is the length XI of each of the third and fourth side surfaces 413 and 414. The length of the body 410 may be a width in a second axis (Y) direction and also a length of each of the long side surfaces that is the length Y1 of each of the third and fourth side surfaces 413 and 414. The first and second axes (X and Y) directions may be perpendicular to each other.

The body 410 includes a cavity 415. The cavity 415 may be provided in a shape in which the inside of the body 410 is recessed from a top surface thereof. A plurality of lead frames 421 and 431 may be exposed in the cavity 415.

Guide protrusions 418 and 419 are disposed around an upper portion of the body 410. The guide protrusions 418 and 419 may guide insertion of the reflective frame 440 to prevent the reflective frame 440 from horizontally moving. The guide protrusions 418 and 419 may be disposed to be spaced apart from each other and include a first guide protrusion 418 and a second guide protrusion 419. The first guide protrusion 418 may extend upward from the third side surface 413 of the body 410 up to a portion above the first and second side surfaces 411 and 412. The second guide protrusion 419 may extend upward from the fourth side surface 414 of the body 410 up to a portion above the first and second side surfaces 411 and 412. The top surfaces of the first and second guide protrusions 418 and 419 may be the top surface of the body 410.

A hook protrusion 417 is disposed around an upper portion of the cavity 415. The hook protrusion 417 may have a structure that is stepped from each of the guide protrusions 418 and 419 of the body 417, for example, have a stair-type structure, a tilted structure, or a curved structure. The hook protrusion 417 functions as a support part supporting the reflective frame 440. The hook protrusion 417 is disposed more adjacent to the top surface of the body 410 than the bottom of the cavity 415.

Referring to FIGS. 2 to 5, a first lead frame 421 may be disposed in a first region on the bottom of the cavity 415 of the body 410. As illustrated in FIG. 5, a protrusion 425 of the first lead frame 421 may protrude outward from the first side surface 411 of the body 410. A second lead frame 431 may be disposed in a second region on the bottom of the cavity 415. As illustrated in FIG. 5, a protrusion 435 of the second lead frame 435 may protrude outward from the second side surface 412 of the body 410. The protrusions 425 and 435 of the first and second lead frames 421 and 431 may increase a contact area and a heat dissipation area to improve solder bonding and heat dissipation.

Stepped structures 422 and 423 may be provided on a lower portion of the first lead frame 421 as illustrated in FIG. 4. The stepped structures 422 and 423 may enhance coupling force with the body 410.

Stepped structures 424 and 434 may be provided on upper portions of the first and second lead frames 421 and 431 as illustrated in FIG. 5. The stepped structures 424 and 434 may enhance coupling force with the body 410.

Also, at least one hole (not shown) may be defined in each of the first and second lead frames 421 and 431. A portion of the body 410 may be coupled to the hole.

Each of the lead frames 421 and 431 may include a metal material, for example, at least one of titanium (Ti), copper (Cu), nickel (Ni), gold (Au), chrome (Cr), tantalum (Ta), platinum (Pt), tin (Sn), silver (Ag), and phosphorous (P) and be provided as a single metal layer or a multilayered metal layer. The lead frames 421 and 431 may have the same thickness. Each of the lead frames 421 and 431 may function as a terminal for supplying power.

The reflective frame 440 is disposed on the body 410. The reflective frame 440 may be disposed to overlap an upper side of a region of the cavity 415. The reflective frame 440 is disposed on the first and second lead frames 421 and 431. The reflective frame 440 may be disposed to vertically overlap the first and second lead frames 421 and 431 in the region of the cavity 415.

An adhesion member 460 may be disposed between the reflective frame 440 and the body 410. The adhesion member 460 allows the reflective frame 440 to adhere to the cavity 415 of the body 410. The adhesion member 460 may include an adhesive such as silicon or epoxy. The adhesion member 460 may be made of the same material as the body 410. A portion of the reflective frame 460 may come into direct contact with the body 410. The adhesion member 460 may be omitted, but is not limited thereto.

The reflective frame 440 may be made of a metal material. The reflective layer 440 may be made of at least one of Ag, Ni, Al, Rh, Pd, Ir, Ru, Mg, Zn, Pt, Cu, Au, Hf or an alloy selected from the materials. The reflective frame 440 may be made of a non-metal material having reflectivity higher than that of the body 410. The reflective frame 440 may be made of the same material as the body, e.g., a material having reflectivity higher than that of the body 410. The light reflectivity of the reflective frame 440 may be greater than that of the body 410.

As illustrated in FIGS. 4 and 5, the reflective frame 440 includes at least one opening portion 445 through which light is emitted. The opening portion 445 may vertically overlap at least one light-emitting chip 450. The opening portion 445 may be a hole vertically passing through a top surface of the light-emitting chip 450. The opening portion 445 may have a rhombus shape having a polygonal shape, a circular shape, an oval shape, or a curved shape in a shape of an upper portion thereof and a polygonal shape having a polygonal shape, a circular shape, an oval shape, or a curved shape in a shape of a lower portion thereof.

The opening portion 445 may be defined along a periphery of the light-emitting chip 450 to open an upper portion of the light-emitting chip 450. The opening portion 445 may be a region through which light emitted from the light-emitting chip 450 is emitted.

The opening portion 445 has a side surface 442 that is disposed adjacent to the light-emitting chip 450 downward. The side surface 442 of the opening portion 445 has a tilted surface. The tilted surface may have a linear shape in which a line connecting an upper end to a lower end of the opening portion 445 is horizontal or a concavely or convexly curved shape. The side surface 442 of the opening portion 445 may have the tiled surface that is a curved or flat surface.

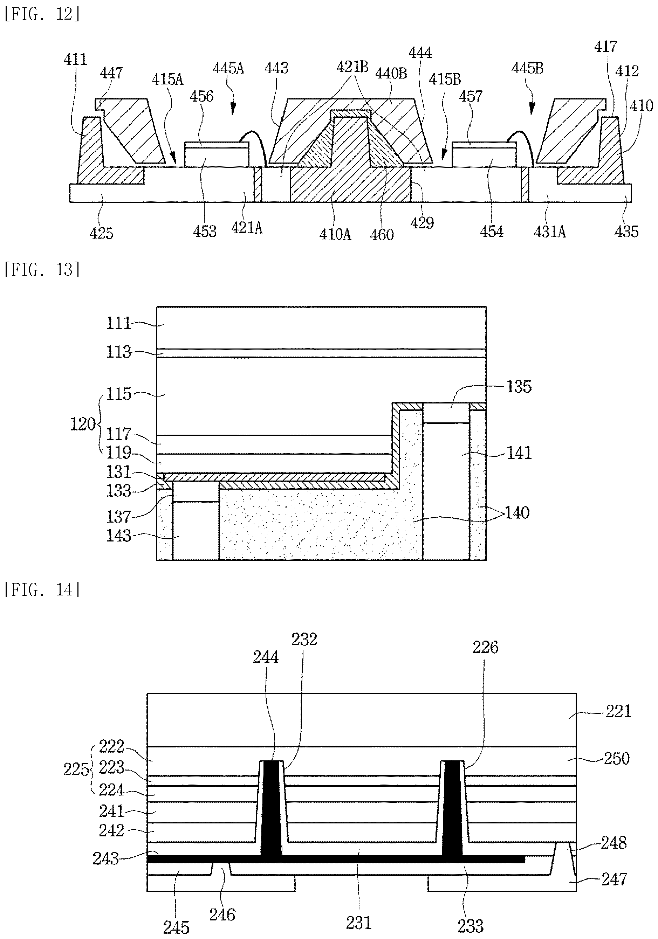

The side surface 442 of the opening portion 445 of the reflective frame 440 may be disposed around each of the light-emitting chips 450. The lower end 441 of the opening portion 445 may be disposed at a position lower than that of the top surface of the light-emitting chip 450. For example, the lower end 441 of the opening portion 445 may be disposed at a position lower than that of an active layer (see reference numeral 317 of FIG. 13) of the light-emitting chip 450. Thus, the side surface 442 of the opening portion 445 of the reflective frame 440 may effectively reflect light emitted from the active layer.

As illustrated in FIG. 4, the lower end 441 of the side surface of the opening portion 445 may be spaced a predetermined distance G1 from the top surface of each of the first and second lead frames 421 and 431. For example, the lower end 441 of the side surface of the opening portion 445 may be spaced a distance G1, i.e., 50 *µ*m or more, e.g., a range of 80 *µ*m to 150 *µ*m from the first lead frame 421. When the lower end 441 of the side surface of the opening portion 445 is disposed to a distance less than the above-described range, the opening portion 445 may electrically interfere with the first and second lead frames 421 and 431. On the other hand, when the lower end 441 of the side surface of the opening portion 445 is disposed to a distance greater than the above-described range, light loss may occur.

The lower end 441 of the side surface of the opening portion 445 may be spaced a predetermined distance G2 from the light-emitting chip 450. For example, the lower end 441 of the side surface of the opening portion 445 may be spaced a predetermined distance G2, i.e., 80 *µ*m or more, e.g., a range 90 *µ*m to 120 *µ*m from the light-emitting chip 450. When the distance G2 between the lower end 441 of the side surface of the opening portion 445 and the light-emitting chip 450 is less than the above-described range, it may be difficult to secure a process error when the light-emitting chip 450 is mounted. On the other hand, when the distance G2 is greater than the above-described range, the opening portion 445 may increase in size to cause insignificant improvement in light extraction efficiency.

The opening portion 445 of the reflective frame 440 may a bottom surface area greater than a top surface area of the light-emitting chip 450 and less than a top surface area of the first lead frame 421 exposed to the cavity 415. The opening portion 445 may have a bottom surface area less than a top surface area thereof.

A width of the bottom surface of the opening portion 445 in the first axis (X) direction may be greater than that of the top surface of the light-emitting chip 450 in the first axis (X) direction and less than that of the top surface of the first lead frame 421 exposed to the cavity 415 in the first axis (X) direction.

A stopping protrusion 447 may be disposed on outer periphery of the reflective frame 440. The stopping protrusion 447 may extend or protrude upward from the hook protrusion 417 of the body 410. The stopping protrusion 447 may be placed on the hook protrusion 417 of the body 410 to come into contact with the hook protrusion 417 of the body 410. Since the stopping protrusion 447 is hooked with the hook protrusion 417 of the body 410, an inserted depth of the reflective frame 440 or a distance between the reflective frame 440 and each of the first and second lead frames 421 and 431 may be adjusted.

The light-emitting chip 450 is disposed on at least one of the first lead frame 421 and the second lead frame 431 and electrically connected to the first and second lead frames 421 and 431. The light-emitting chip 450 may be connected to at least one of the first and second lead frames 421 and 431 through a conductive adhesive or conductive bump. The light-emitting chip 450 may be connected in a flip chip manner or connected by using at least one wire or a plurality of wires. The light-emitting chip 450 may have a horizontal chip or vertical chip structure, but is not limited thereto.

The light-emitting chip 450 may selectively emit light in a range from a visible light band to an ultraviolet light band. For example, the light-emitting chip 450 may be one selected from a red LED chip, a blue LED chip, a green LED chip, a yellow green LED chip, and a white LED chip. The light-emitting chip 450 may include an LED chip including at least one of the group III-V and/or II-VI compound semiconductors. The light-emitting device may include the light-emitting chip 450 having a large areas, for example, 0.6 mm or more or 1 mm or less to improve intensities of light.

A protection chip (not shown) may be disposed on at least one of the first and second lead frames 421 and 431. The protection chip may be connected to the light-emitting chip 450 in parallel to protect the light-emitting chip 450. The protection chip may be implemented with at least one of a thyristor, a Zener diode, or a transient voltage suppression (TVS).

A phosphor film 445 may be disposed on the light-emitting chip 450. The phosphor film 455 may include at least one phosphor of red, green, and blue phosphors. For example, the light-emitting chip 450 emits blue light, the phosphor film 455 may include a yellow phosphor or green and red phosphors.

For another example, the light-emitting chip 450 emits UV light, the phosphor film 455 may include at least one or all of blue, green, and red phosphors.

For another example, the phosphor film 455 may not be provided on the light-emitting chip 450 and thus may include a phosphor for converting a wavelength of light in a molding member (not shown). The phosphor may be selected from YAG, TAG, silicate, nitride, oxy-nitride-based materials. The phosphor may include at least one of a red phosphor, a yellow phosphor, a blue phosphor, and a green phosphor, but is not limited thereto. The phosphor may include phosphors emitting light having different colors on the light-emitting chip 450, but is not limited thereto.

The molding member (not shown) may be disposed in the cavity 415 and the region of the opening portion 445. The molding member (not shown) may be made of a light transmissive material such as silicon or epoxy and be provided as a single layer or multilayer. The molding member (not shown) may have a surface having at least one of a flat shape, a concave shape, and a convex shape, but is not limited thereto.

An optical lens may be coupled to the opening portion 445 of the reflective frame 440. The optical lens may include a convex lens, a concave lens, or a convex lens having a total reflective surface at a central portion thereof with respect to the light-emitting chip 450, but is not limited thereto. The optical lens may include a Fresnel lens.

Referring to FIGS. 6 to 8, a structure of the reflective frame 440 will be described in detail. When a vertical direction with respect to a center of the opening portion 445 of the reflective frame 440 or a center of the light-emitting chip 450 is defined as an optical axis (Z) direction, the optical axis (Z) direction may be defined in the first axis (X) direction perpendicular to the optical axis (Z) direction and the second axis (Y) direction perpendicular to the first axis (X) direction.

An axis direction having an isogonic angle (e.g., 45 degrees) with respect to the first and second axes (X and Y) between the first and second axes (X and Y) is defined as a third axis (W) direction. The third axis (W) direction may be a direction passing through a diagonal direction from a center of the light-emitting chip 450. The first to third axes X, Y, and W may be defined on the same plane and perpendicular to the optical axis Z.

Referring to FIGS. 2 and 6, a central portion of two side surfaces S1 opposite to each other of the side surfaces of the light-emitting chip 450 from the optical axis Z may be disposed on a straight-line in the first axis (X) direction and pass through the first and second lead frames 421 and 431. A central portion of two side surfaces S2 opposite to each other of the side surfaces of the light-emitting chip 450 from the optical axis Z may be disposed on a straight-line in the second axis (Y) direction and pass through the first or second lead frame 421 to 431. The straight-line in the third axis (W) direction may pass through a diagonal direction of the light-emitting chip 450 from the optical axis Z and also pass through the first and second lead frames 421 and 431.

Referring to FIG. 6, a center PI of the bottom surface of the opening portion 445 and a center P2 of a top surface of the opening portion 445 may be disposed on the optical axis Z and disposed at a center of the light-emitting chip 450. A boundary of the bottom surface or lower end of the opening portion 445 may be defined as a first outline A0, and a boundary of the top surface or upper end of the opening portion 445 may be defined as a second outline B0.

The first outline A0 includes a first point A1 crossing a straight-line in the first axis (X) direction from the center PI of the bottom surface of the opening portion 445, a second point (A2) crossing a straight-line in the second axis (Y) direction, and a third point A3 crossing a straight-line in the third axis (W) direction. The first point A1 may be a region adjacent to the first side surface S1 of the light-emitting chip 450, and the second point A2 may be a region adjacent to the second side surface S2 of the light-emitting chip 450, and the third point A3 may be a region adjacent to a corner region S3 between the first and second side surfaces S1 and S2 of the light-emitting chip 450.

The second outline B0 includes a fourth point B1 crossing a straight-line in the first axis (X) direction from the center P2 of the top surface of the opening portion 445, a fifth point (B2) crossing a straight-line in the second axis (Y) direction, and a sixth point B3 crossing a straight-line in the third axis (W) direction.

A first distance D1 from the center PI of the bottom surface of the opening portion 445 or the optical axis Z to the first point A1 disposed on the first axis X of the first outline A0 may be equal to or greater than a second distance D2 up to the second point A2 disposed on the second axis Y. A ratio of the first distance D1 to second distance D2 may be a ratio of lengths of the second side surface S2 and the first side surface S1 of the light-emitting chip, for example, a ratio of D1:D2 may be a ratio of lengths of S2:S1 or a ratio of 1:0.8 to 1:1. When the second distance D2 is greater by the ratio or more than the first distance D1, illuminance distribution in the second axis (Y) direction may have distribution that is not uniform when compared to illuminance distribution in the first axis (X) direction. When the light-emitting chip 450 has a rectangular shape or square shape, the light-emitting chip 450 may be spaced the same distance from the first and second points A1 and A2.

A third distance D3 from the center PI of the bottom surface of the opening portion 445 or the optical axis Z to the third point A3 disposed on the third axis W of the first outline A0 may be greater than one or all of the first and second distances D1 and D2. Thus, a distance between the corner region S3 of the light-emitting chip 450 and the third point A3 may be equal to or different from that between each of the side surfaces S1 and S2 of the light-emitting chip 450 and each of the first and second points A1 and A2. For example, when the distance between the corner region S3 of the light-emitting chip 450 and the third point A3 may be equal to that between each of the side surfaces S1 and S2 of the light-emitting chip 450 and each of the first and second points A1 and A2, each of the points A1, A2, and A3 of the inner surface 442 of the opening portion 445 may be equal to the distance between each of the side surfaces S1 and S2 of the light-emitting chip 450 and the corner region S3. Each of a line connecting the first point A1 to the third point A3 and a line connecting the third point A3 to the second point A2 may have a curved line.

A fourth distance D4 from the center P2 of the top surface of the opening portion 445 or the optical axis Z to the fourth point B1 disposed on the first axis X of the second outline B0 may be equal to or greater than a fifth distance D5 up to the fifth point B2. A ratio of the fourth distance D4 to the fifth distance D5 may be equal to that of the first and second distances D1 and D2, and illuminance distribution in the first axis (X) direction and the second axis (Y) direction may vary to the ratio.

A sixth distance D6 from the center P2 of the top surface of the opening portion 445 to the sixth point B3 disposed on the third axis W may be less than one or all of the fourth and fifth distances D4 and D5. Thus, an amount of light reflected from a region corresponding to each of the corner regions S3 of the light-emitting chip 450 to an opposite region in the region of the inner surface 442 of the opening portion 445 may increase.

A first segment R1 connecting the first point A1 of the first outline A0 to the fourth point B1 of the second outline B0 of the opening portion 445 may be tilted at a first angle θ1 with respect to the optical axis Z, a second segment R2 connecting the second point A2 to the fifth point B2 may be tilted at a second angle θ2 with respect to the optical axis Z, and a third segment R3 connecting the third point A3 to the sixth point B3 may be tilted at a third angle θ3 with respect to the optical axis Z. The third angle θ3 may be less than one or all of the first and second angles θ1 and θ2.

An inclination of the third segment R3 is greater than that of each of the first and second segments R1 and R2. The inclination of the third segment R3 may be an exterior angle between the third segment R3 and the third axis W, the inclination of the first segment R1 may be an exterior angle between the first segment R1 and the first axis X, and the inclination of the second segment R2 may be an exterior angle between the second segment R2 and the second axis Y.

An inclination of each of regions S11, S12, and S13 that is tilted to the inner surface 442 of the opening portion 445 may be an exterior angle between the inner surface 442 of the opening portion 445 and the regions S11, S12, and S13 disposed on the first, second, and third axes Z, Y, and Z. The inclination of each of the regions S11, S12, and S13 that is tilted to the inner surface 442 of the opening portion 445 may be obtained by a difference in slope of the first to third segments R1, R2, and R3. The side surface 442 adjacent to the first to third segments R1, R2, and R3 may be a flat or curved surface, but is not limited thereto.

The regions S11, S12, and S13 of the inner surface 442 include the first axis X and a first reflective region S11 adjacent to the first axis X, the second axis Y and a second reflective region S12 adjacent to the second axis Y, and the third axis W and a third reflective region S13 adjacent to the third axis W.

The first reflective region S11 disposed on the first axis X and the second reflective area S12 disposed on the second axis Y gradually increase in inclination as being adjacent to the third reflective region S13 disposed on the third axis W or the third segment R3. The inner surface 442 of the opening portion 445 gradually increases in inclination as being adjacent to the third axis W. On the other hand, the inner surface 442 of the opening portion 445 gradually decreases in inclination as being away from the third axis W.

The side surface 442 of the opening portion 445 includes the first reflective region S11 adjacent to the first side surface S1 of the light-emitting chip 450 or disposed in the first axis (X) direction, the second reflective region S12 adjacent to the second side surface S2 of the light-emitting chip 450 or disposed in the second axis (Y) direction, and the third reflective region S13 adjacent to the corner region S3 of the light-emitting chip 450 or disposed in the third axis (W) direction. An inclination of the third reflective region S13 is greater than that of each of the first and second reflective regions S11 and S12. Each of the first and second reflective regions S11 and S12 gradually increase in inclination as being close to the third reflective region S13.

The third reflective region S13 having the third segment R3 is a region adjacent to the corner region S3 of the light-emitting chip 450 and is disposed between the first reflective region S11 having the first segment R1 and the second reflective region S12 having the second segment R2. The third reflective region S13 reflects light incident from the light-emitting chip 450 to an opposite side by the inclination or the third angle θ3 to improve the illuminance distribution in the diagonal direction in the camera module and reduce a deviation in illuminance distribution in the diagonal direction and illuminance distribution in the central portion.

The opening portion 445 may have a height HI greater 1,8 times to 2.2 times than the fourth distance D4, e.g., ranging from 2 mm to 3 mm. When the height HI of the opening portion 445 is less than the above-described range, it may be difficult to couple the constituents such as the optical lens and collect light. When the height HI of the opening portion 445 is greater than the above-described range, the camera module may increase in thickness.

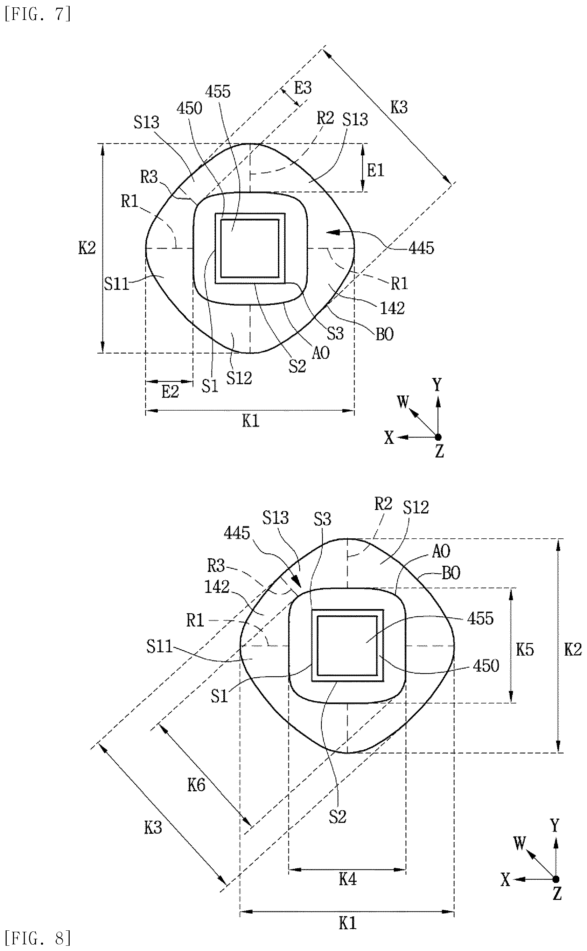

Referring to FIGS. 6 and 8, in the width of the top surface of the opening portion 445, a width K1 of the top surface in the first axis (X) direction and a width K2 of the top surface in the second axis (Y) direction is greater than that K3 of the top surface in the third axis (W) direction, and a length E3 of the third segment R3 is less than that E1 or E2 of each of the first and second segments R1 and R2. Since the inclination of the third segment R3 is greater than that of each of the first and second segments R1 and R2, the difference in width and length is provided as described above. In addition, an amount of light reflected between the regions having the third segments R3, which face each other, may be increase. Each of the distances E1, E2, and E3 between the first outline A0 of the lower end and the second outline B0 of the upper end of the side surface 442 may gradually decrease as being adjacent to the third axis W.

Referring to FIGS. 7 and 8, in the width of the bottom surface of the opening portion 445, a width K4 of the bottom surface in the first axis (X) direction and a width K5 of the bottom surface in the second axis (Y) direction may be equal to or greater than that K5 of the bottom surface in the second axis (Y) direction. The width K6 of the bottom surface in the third axis (W) direction may be greater than that K4 or K5 of each of the bottom surfaces in the first and second axes X and Y.

In an embodiment, a width K6 of the bottom surface in the third axis (W) direction of the widths of the bottom surface of the opening portion 445 of the reflective frame 440 may be greater than that K4 or K5 of each of the bottom surfaces in the first and second axes (X, Y) directions, and the width K1 or K2 of the top surface in the first or second axis (X or Y) direction of the widths of the top surface of the opening portion 445 may be greater than that K3 of the top surface in the third axis (W) direction.

Also, the first to third segments R1, R2, and R3 of the opening portion 445 may gradually decrease in length and increase in inclination as being close to the third segment R3 adjacent to the corner region S3 of the light-emitting chip 450. Thus, an illuminance surface of light emitted from the light-emitting device may have a rectangular shape to improve the illuminance distribution in the diagonal direction.

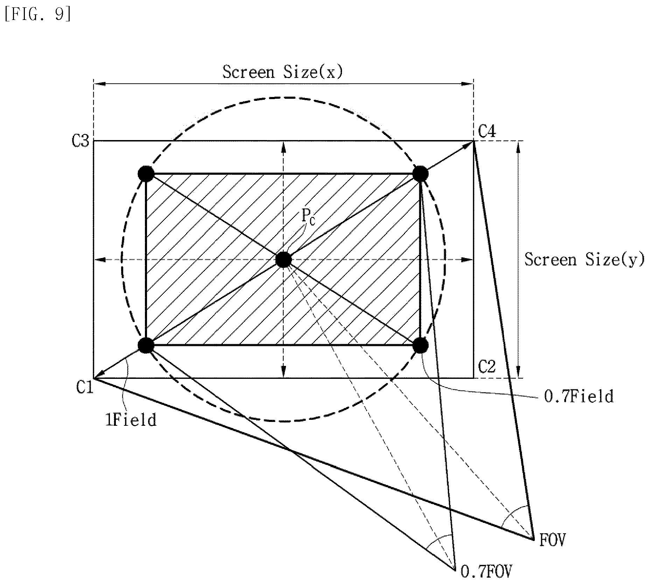

FIG. 9 is a view for explaining a method for comparing light uniformity in the camera module.

Referring to FIG. 9, if an output screen of the camera module has a ratio (x:y) of 4:4, when a diagonal length of a rectangular shape corresponding to the ratio is 1 field, i.e., when a diagonal length of the rectangular shape is 100%, a diameter of a circle passing through the rectangular shape may be 0.7 fields or 70%. When 1 field is measured at a predetermined distance (for example, 1 m) from a center Pc of the circle, it is called a field of view (FOV). Here, when 0.7 fields are measured, it may be defined as 0.7 FOV. Here, the predetermined distance may be a distance up to a surface (to be irradiated) on which the camera module is evaluated. The light-emitting device may be defined as a flash device.

A light receiving sensor is disposed in a circle having a diagonal length of the 0.7 field square as a diameter and in an edge area C1, C2, C3, and C4 of a 0.7 field square, thereby measuring the light uniformity of the camera module.

Referring to FIGS. 2 and 9, the light-emitting device 400 according to an embodiment according to the invention lowers central illuminance of light emitted from the light-emitting chip 450 by the opening portion 445 of the reflective frame 440 and increases the illumination intensity of the 1.0 field. Thus, a difference in illuminance between the central illuminance and the 1.0 filed may be improved. The light-emitting device 400 according to an embodiment according to the invention compensates the illuminance in the diagonal direction or the corner region C1, C2, C3, and C4 to reduce a deviation in the illuminance distribution over the entire area of the screen.

Table 1 shows results obtained by comparing samples #0 to #6 to each other according to an embodiment. The samples #0 to #6 represent distances D2, D3, D4, D5, and D6 with respect to the first distance D1 of the opening portion 445, D6, and a height HI, respectively. Here, a unit of numerical values in Table 1 may be a ratio therebetween.

Table 2 shows an inclination of the side 442 of the opening portion 445 in the first axis (X) direction, an inclination in the second axis (Y) direction, and an inclination of the second axis (Y) direction in the samples #0 to #6 of Table 1 and also shows ratios of illuminance distribution in the camera module.

**[Table 1]**

| Classification | HI | D5 | D2 | D6 | D3 | D4 | D1 |
|---|---|---|---|---|---|---|---|
| Sample#0 | 2.380 | 1.728 | 0.940 | 1.546 | 1.118 | 1.687 | 1 |
| Sample#1 | 2.380 | 1.728 | 0.940 | 1.617 | 1.118 | 1.687 | 1 |
| Sample#2 | 2.380 | 1.728 | 0.940 | 1.898 | 1.118 | 1.687 | 1 |
| Sample#3 | 2.380 | 1.728 | 0.940 | 1.997 | 1.118 | 1.687 | 1 |
| Sample#4 | 2.380 | 1.728 | 0.940 | 1.617 | 1.005 | 1.687 | 1 |
| Sample#5 | 2.380 | 1.728 | 0.940 | 1.748 | 1.005 | 1.687 | 1 |
| Sample#6 | 2.380 | 1.728 | 0.940 | 1.798 | 1.005 | 1.687 | 1 |

**[Table 2]**

| Classification | X-inclination | W-inclination | Y-inclination | 1.0F (FOV72) | 1.0F/X | 1.0F/Y |
|---|---|---|---|---|---|---|
| Sample#0 | 3.020305 | 5.560748 | 3.464338 | 30.0% | 44.8% | 55.0% |
| Sample#1 | 3.020305 | 4.769539 | 3.464338 | 24.2% | 37.0% | 48.5% |
| Sample#2 | 3.020305 | 3.051282 | 3.464338 | 18.6% | 25.2% | 47.7% |
| Sample#3 | 3.020305 | 2.707622 | 3.464338 | 18.6% | 24.8% | 53.4% |
| Sample#4 | 3.020305 | 3.888889 | 3.464338 | 20.5% | 37.7% | 45.9% |
| Sample#5 | 3.020305 | 3.20323 | 3.464338 | 15.2% | 28.1% | 39.9% |
| Sample#6 | 3.020305 | 3.001261 | 3.464338 | 14.4% | 26.4% | 40.7% |

Referring to FIG. 6, In Table 2, the X-inclination is an inclination of the first segment R1 in the first axis direction, the Y-inclination is an inclination of the second segment R2 in the second axis (Y2) direction, and the W-inclination is an inclination of the third segment R3 in the direction of the third axis (W) direction which is a 45 degree direction of the X axis and the Y axis, 1.0F is a brightness ratio of the edge portion to the central illuminance, and 1.0F/X is a brightness ratio in the corner region in the first axis (X) direction to the central illuminance, and 1.0F/Y is a brightness ratio in the edge area in the second axis (Y) direction to the central illuminance.

The X-inclination is obtained by H1/(D4-D1), the Y-inclination is obtained by H1/(D5-D2), and the W-inclination is obtained by H1/(D6-D3). The value of the Y-inclination may be greater than either or both of the X-inclination value and the Y-inclination value.

Referring to Table 2, when the W-inclination is greater than the inclination in the X or Y axis direction as shown by the samples #0, #1, and #4, it is seen that the illuminance distribution at 1.0F is 20% or more. Accordingly, since the inclination of the side surface of the opening portion according to an embodiment is adjusted to correspond to the position of the light-emitting chip, the illuminance distribution of the camera module, particularly, the illuminance distribution in the diagonal region may further increase.

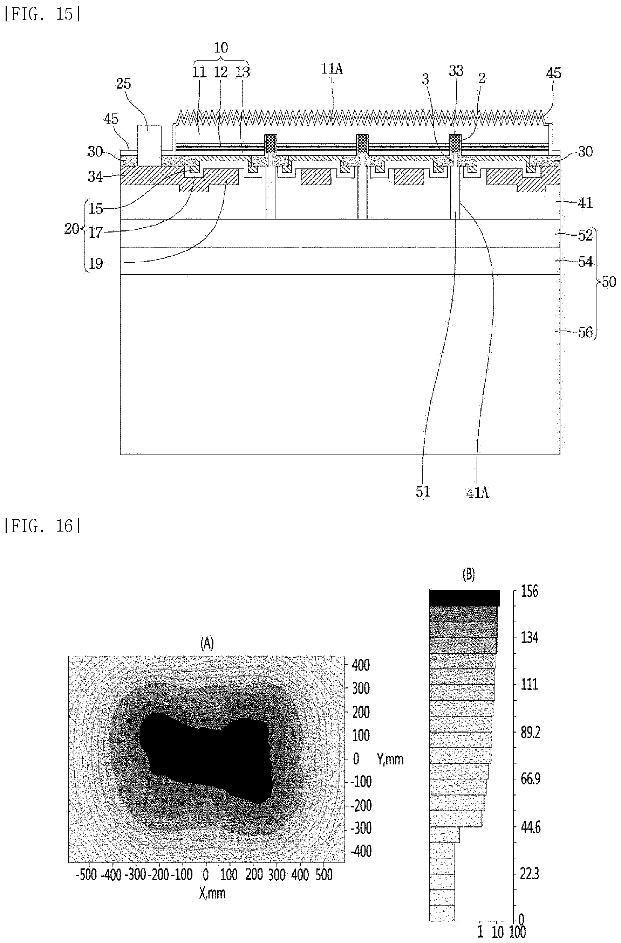

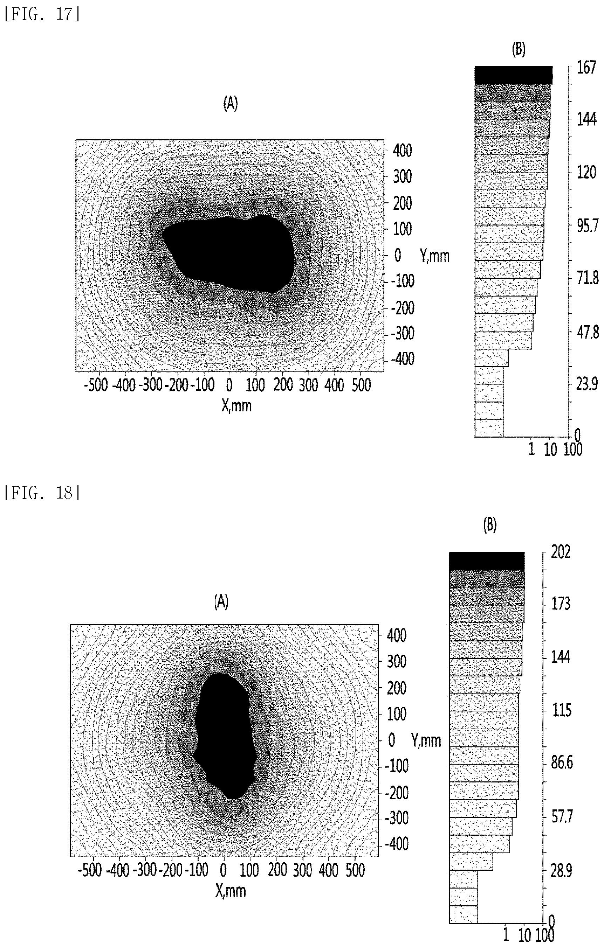

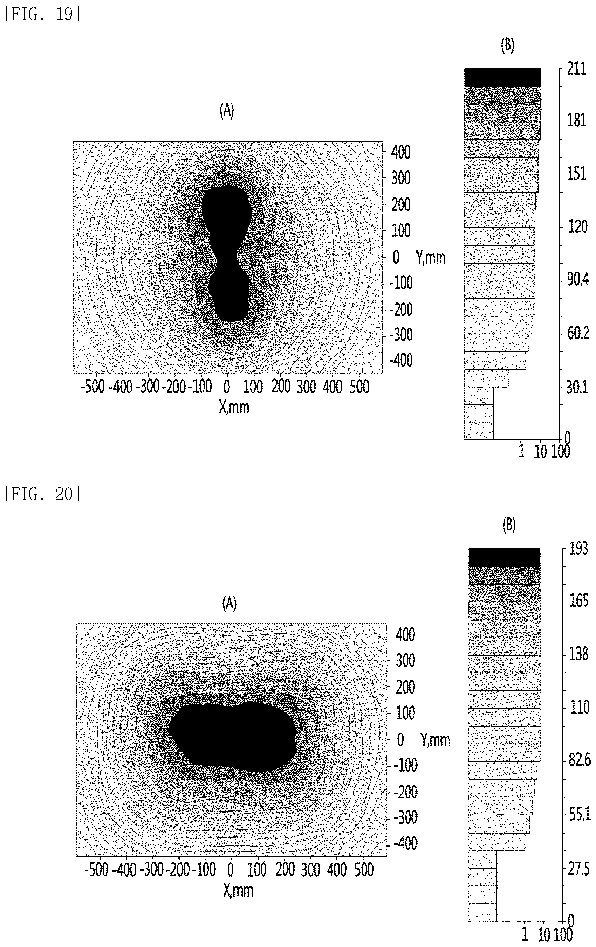

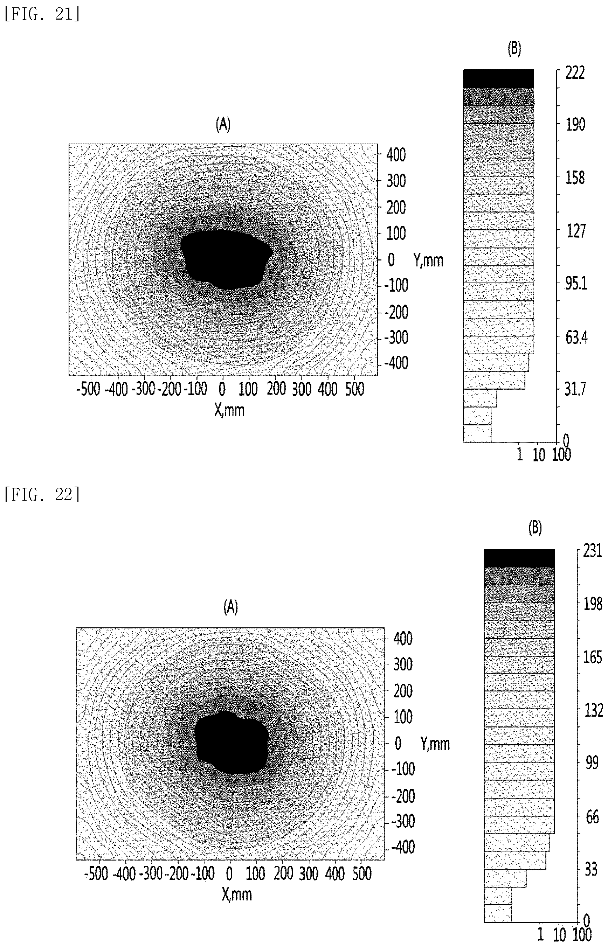

FIGS. 16A to 22A and 16B to 22B show the illuminance distributions and the center brightness of the samples #0 to #6, respectively. FIG. 16 shows the illuminance distributions and the center brightness of the sample #0 Tables 1 and 2, FIG. 17 shows the illuminance distributions and the center brightness of the sample #1 in Tables 1 and 2, FIG. 18 shows the illuminance distributions and the center brightness of the sample #2 in Tables 1 and 2, FIG. 19 shows the illuminance distributions and the center brightness of the sample #3 in Tables 1 and 2, FIG. 20 shows the illuminance distributions and the center brightness of the sample #4 in Tables 1 and 2, FIG. 21 shows the illuminance distributions and the center brightness of the sample #5 in Tables 1 and 2, and FIG. 22 shows the illuminance distributions and the center brightness of the sample #6 in Tables 1 and 2. Here, in the sample #0 shown in FIG. 16, the illuminance of the edge area has an illuminance deviation of less than 15% as compared with the outer region in the X-axis direction and the Y-axis direction.

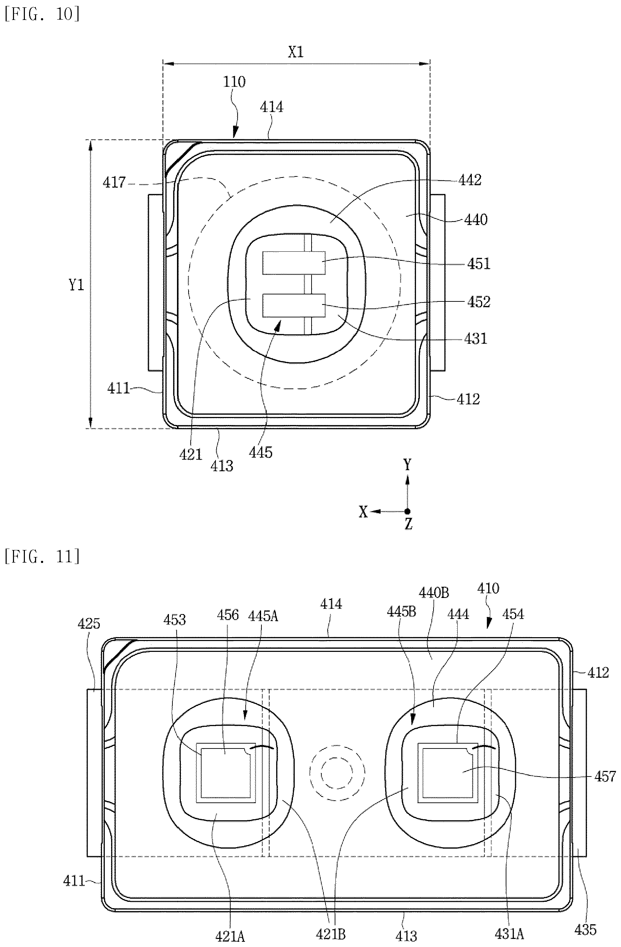

FIG. 10 is a view illustrating another example according to the invention of the light-emitting device of FIG. 2.

Referring to FIG. 10, a light-emitting device includes a plurality of light-emitting chips 451 and 452 disposed under an opening portion 445 of a reflective frame 440. Two light-emitting chips 451 and 452 may be disposed in a first axis (X) direction or in a second axis (Y) direction. For another example, three light-emitting chips (not shown) may be disposed in a region within an angle of 120 degrees with respect to a center. For another example, four light-emitting chip may be arranged in the form of a matrix around the center.

The reflective frame 440 of the light-emitting device is coupled to a body 410, and the opening portion 445 of the reflective frame 440 has an opened structure on the plurality of light-emitting chips 451 and 452. This will be described with reference to the foregoing embodiments. A rectangular shape connecting the outermost edge points of the plurality of light-emitting chips may correspond to a rectangular shape of the light-emitting chip of FIG. 1 to provide the inclination of the opening portion 445.

FIGS. 11 and 12 are views illustrating another example according to the invention of the light-emitting device of FIG. 2.

Referring to FIGS. 11 and 12, a light-emitting device includes a body 410, a plurality of lead frames 421A, 421B, and 431A coupled to the body 410, a reflective frame 440B having a plurality of opening portions 445A and 445B, light-emitting chips 453 and 454 disposed under the opening portions 445A and 445B.

The plurality of lead frames 421A, 421B, and 431A may be coupled to the inside of the body 410. The plurality of lead frames 421A, 421B, and 431A may include two or more lead frames, for example, three or more lead frames. A first part of each of the first and second lead frames 421A and 421B may be disposed under the first opening portion 445A of the reflective frame 440B, and a second part of the second lead frame 421B and the third lead frame 431A may be disposed under the second opening portion 445B. Each of the first opening portion 445A and the second opening portion 445B of the reflective frame 440B are the same as the opening portion 445 of FIGS. 6 to 8, the first opening portion 445A and the second opening portion 445B will be described with reference to the above-described descriptions. For example, a side surface 443 of the first opening portion 445A and a side surface 444 of the second opening portion 445B will be described with reference to the descriptions of FIGS. 6 to 8 according to the foregoing embodiments.

The second light-emitting chip 453 disposed under the first opening portion 445A may emit the same light as the second light-emitting chip 454 disposed under the second opening portion 445B or light having a different color. The first-light-emitting chip 453 may be disposed at least one of the first parts of the first and second lead frames 421A and 421B, and the second light-emitting chip 454 may be disposed on at least one of the second part of the second lead frame 421B disposed under the second opening portion 445 and the third lead frame 431A.

As illustrated in FIG. 12, a hole 429 may be defined in the second lead frame 421B, and a portion 410A of the body 410 may be coupled to the hole 429. An adhesion member 460 may be disposed on a region between the body 410 and the reflective frame 440B.

The body 410 may have a first cavity 415A under the first opening portion 445A and a second cavity 415B under the second opening portion 445B, and the first and second cavities 415A and 415B may be spaced apart from each other.

A first phosphor film 456 may be disposed on the first light-emitting chip 453, and a second phosphor film 457 may be disposed on the second light-emitting chip 454. The first phosphor film 456 and the second phosphor film 457 may be the same or different from each other. For example, when each of the first and second light-emitting chips 453 and 454 emits blue light, the first phosphor film 456 may have a yellow phosphor, and the second phosphor film 457 may have a red phosphor.

For another example, when each of the first and second light-emitting chips 453 and 454 emits blue light, the first phosphor film 456 may have a green phosphor, and the second phosphor film 457 may have a red phosphor.

For another example, when each of the first and second light-emitting chips 453 and 454 emits blue light, the first phosphor film 456 may have yellow and green phosphors, and the second phosphor film 457 may have red and green phosphors.

For another example, when each of the first and second light-emitting chips 453 and 454 emits UV light, the first phosphor film 456 may have blue and red phosphors, and the second phosphor film 457 may have a green phosphor. A kind of phosphors within the phosphor films 456 and 457 may vary according to a kind of light-emitting chips 453 and 454, but is not limited thereto.

FIG. 13 is a view illustrating an example of the light-emitting chip that can be used in an embodiment of the invention as defined by the claims.

Referring to FIG. 13, the light-emitting chip may include a substrate 111, a first semiconductor layer 113, a light-emitting structure 120, an electrode layer 131, an insulation layer 133, a first electrode 135, a second electrode 137, a first connection electrode 141, a second connection electrode 143, and a support layer 140.

The substrate 111 may include a transmissive, insulating, or conductive substrate. For example, the substrate 111 may be made of at least one of sapphire (Al₂O₃), SiC, Si, GaAs, GaN, ZnO, Si, GaP, InP, Ge, and Ga₂O₃. A plurality of convex portions (not shown) may be disposed on at least one or all of top and bottom surfaces of the substrate 111 to improve light extraction efficiency. Each of the convex portions may include a hemispheric shape, a semi-elliptical surface, or a polygonal shape in a lateral cross-section. Here, the substrate 111 may be removed from the inside of the light-emitting chip. In this case, the first semiconductor layer 113 or a first conductive type semiconductor layer 115 may be disposed on the top surface of the light-emitting chip.

The first semiconductor layer 113 may be disposed under the substrate 111. The first semiconductor layer 113 may be made of the group II-V compound semiconductors. The first semiconductor layer 113 may be provided as at least one layer or plurality of layers by using the group II-V compound semiconductors. The first semiconductor layer 113 may include at least one of semiconductor layers using the group III-V compound semiconductors, e.g., GaN, InN, AlN, InGaN, AlGaN, InAlGaN, AlInN, AlGaAs, GaP, GaAs, GaAsP, AlGaInP, and GaP. The first semiconductor layer 113 may have a compositional formula of InxAlyGa1-x-yN (0≤x≤1, 0≤y≤1, 0≤x+y≤1) and include at least one of a buffer layer and an undoped semiconductor layer. The buffer layer may reduce a difference in lattice constant between the substrate and the nitride semiconductor layer, and the undoped semiconductor layer may improve crystalline quality of the semiconductor. Here, the first semiconductor layer 113 may be omitted.

The light-emitting structure 120 may be disposed under the first semiconductor layer 113. The light-emitting structure 120 may be made of a material selected from the group II-V and group III-V compound semiconductors to emit light having a predetermined peak wavelength in a wavelength range of an ultraviolet light band to a visible light band.

The light-emitting structure 120 includes a first conductive type semiconductor layer 115, a second conductive type semiconductor layer 119, and an active layer 117 disposed between the first conductive type semiconductor layer 115 and the second conductive type semiconductor layer 119. The other semiconductor layer may be further disposed on at least one of top and bottom surfaces of each of the layers 115, 117, and 119, but is not limited thereto.

The first conductive type semiconductor layer 115 may be disposed under the first semiconductor layer 113 and realized as a semiconductor into which a first conductive type dopant is doped, e.g., an n-type semiconductor layer. The first conductive type semiconductor layer 115 may include a semiconductor material having a compositional formula of InₓAl_{y}Ga_{1-x-y}N (0≤x≤1, 0≤y≤1, 0≤x+y≤1). The first conductive type semiconductor layer 115 may be made of a material selected from the group III-V compound semiconductors, e.g., GaN, AlN, AlGaN, InGaN, InN, InAlGaN, AlInN, AlGaAs, GaP, GaAs, GaAsP, and AlGaInP. The first conductive type dopant may be an n-type dopant and include a dopant such as Si, Ge, Sn, Se, and Te.

The active layer 117 may be disposed under the first conductive type semiconductor layer 115 and have one of a single quantum well structure, a multi quantum well (MQW) structure, a quantum wire structure, and a quantum dot structure and also have a cycle of a wall layer and a barrier layer. The cycle of the wall layer/barrier layer includes, for example, at least one of pairs of InGaN/GaN, GaN/AlGaN, AlGaN/AlGaN, InGaN/AlGaN, InGaN/InGaN, AlGaAs/GaA, InGaAs/GaAs, InGaP/GaP, AlInGaP/InGaP, and InP/GaAs.

The second conductive type semiconductor layer is disposed under the active layer 117. The first conductive type semiconductor layer 119 may include a semiconductor, into which a second conductive type dopant is doped, having a compositional formula of InₓAl_{y}Ga_{1-x-y}N (0≤x≤2, 0≤y≤1, 0≤x+y≤1). For example, the second conductive type semiconductor layer 119 may be made of at least one of compound semiconductors such as GaN, InN, AlN, InGaN, AlGaN, InAlGaN, AlInN, AlGaAs, GaP, GaAs, GaAsP, and AlGaInP. The second conductive type semiconductor layer 119 may be a p-type semiconductor layer, and the first conductive type dopant may include Mg, Zn, Ca, Sr, or Ba as a p-type dopant.

For another example of the light-emitting structure 120, the first conductive type semiconductor layer 115 may be realized as a p-type semiconductor layer, and the second conductive type semiconductor layer 119 may be realized as an n-type semiconductor layer. Also, a third conductive type semiconductor layer having a polarity opposite to that of the second conductive type semiconductor layer may be disposed on the second conductive type semiconductor layer 119. Also, the light-emitting structure 120 may have one structure of an n-p junction structure, a p-n junction structure, an n-p-n junction structure and a p-n-p junction structure.

The electrode layer 131 may be disposed under the second conductive type semiconductor layer 119. The electrode layer 131 may include a reflective layer. The electrode layer 131 may include a contact layer that comes into contact with the second conductive type semiconductor layer 119 of the light-emitting structure 120. The reflective layer may be made of a material having reflectivity of 70% or more, e.g., one of metals such as Al, Ag, Ru, Pd, Rh, Pt, and Ir and an alloy of two or more metals of the metals. The metal of the reflective layer may come into contact with a bottom surface of the second conductive type semiconductor layer 119. The contact layer may be an ohmic contact layer and be made of a material selected from a light transmission material, a metal material, and a non-metal material.

The electrode layer 131 may have a laminated structure of the light transmission electrode layer/the reflective layer. For example, the light transmission electrode layer may be made of a material selected from indium tin oxide (ITO), indium zinc oxide (IZO), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), Ag, Ni, Al, Rh, Pd, Ir, Ru, Mg, Zn, Pt, Au, Hf, and combinations thereof. The reflective layer made of a metal material may be disposed under the light transmissive electrode layer. For example, the reflective layer may be made of a material selected from Ag, Ni, Al, Rh, Pd, Ir, Ru, Mg, Zn, Pt, Au, Hf, and combinations thereof. For another example, the reflective layer may have a distributed bragg reflection structure in which two layers having different refractive indexes are alternately disposed.

A light extraction structure such as roughness may be formed on a surface of at least one layer of the second conductive type semiconductor layer 119 and the electrode layer 131. The light extraction structure may change a critical angle of incident light to improve light extraction efficiency.

The insulation layer 133 may be disposed under the electrode layer 131, e.g., disposed on a bottom surface of the second conductive type semiconductor layer 119, side surfaces of the second conductive type semiconductor layer 119 and the active layer 117, and a portion of an area of the first conductive type semiconductor layer 115. The insulation layer 133 may be disposed in a region except for the electrode layer 131, the first electrode 135, and the second electrode 137 of a lower region of the light-emitting structure 120 to electrically protect the lower portion of the light-emitting structure 120.

The insulation layer 133 may be made of an insulation material or an insulation resin formed of at least one of oxide, nitride, fluoride, and sulfide, which include at least one of Si, Al, Cr, Si, Ti, Zn, and Zr. The insulation layer 133 may be made of a material selected from, for example, SiO₂, Si₃N₄, Al₂O₃, and TiO₂. The insulation layer 133 may have a single or multi layered structure, but is not limited thereto. When a metal structure for flip bonding is formed under the light-emitting structure 120, the insulation layer 133 may prevent interlayer short-circuit of the light-emitting structure 120 from occurring.

The insulation layer 133 may have a distributed bragg reflector (DBR) structure in which first and second layers having different refractive indexes are alternately disposed. Here, the first layer may be made of one of SiO₂, Si₃N₄, Al2O3, and TiO₂, and the second layer may be made of a material except for the material of the first layer, but is not limited thereto. Alternatively, the first and second layers may be made of the same material or provided as a pair having three or more layers. In this case, the electrode layer may be omitted.

The first electrode 135 may be disposed under a portion of a region of the first conductive type semiconductor layer 115, and the second electrode 137 may be disposed under a portion of the electrode layer 131. The first connection electrode 141 may be disposed under the first electrode 135, and the second connection electrode 143 may be disposed under the second electrode 137.

The first electrode 135 may be electrically connected to the first conductive type semiconductor layer 115 and the first connection electrode 141, and the second electrode may be electrically connected to the second conductive type semiconductor layer 119 and the second connection electrode 143 through the electrode layer 131.

The first electrode 135 and the second electrode 137 may be made of at least one of Cr, Ti, Co, Ni, V, Hf, Ag, Al, Ru, Rh, Pt, Pd, Ta, Mo, and W or an allow thereof and have a single or multilayered structure. The first electrode 135 and the second electrode 137 may have the same laminated structure or different laminated structures. At least one of the first electrode 135 and the second electrode 137 may further include a current spreading pattern having an arm or finger structure. Also, each of the first electrode 135 and the second electrode 137 may be provided in one or plurality, but is not limited thereto. At least one of the first and second connection electrodes 141 and 143 may be provided in plurality, but is not limited thereto.

Each of the first connection electrode and the second connection electrode 143 may function as a lead for supplying power and provide a heat releasing path. Each of the first connection electrode 141 and the second connection electrode 143 may have at least one of a circular shape, a polygonal shape, a cylindrical shape, or a polyprism shape. Each of the first connection electrode 141 and the second connection electrode 143 may be made of a metal powder material, e.g., Ag, Al, Au, Cr, Co, Cu, Fe, Hf, In, Mo, Ni, Si, Sn, Ta, Ti, W, and an alloy selected from the metals. Each of the first connection electrode 141 and the second connection electrode 143 may be formed by plating one metal of In, Sn, Ni, Cu, and an alloy selected from the metals to improve adhesion with the first electrode 135 and the second electrode 137.

The support layer 140 may be made of a hest conductive material and disposed around the first electrode 135, the second electrode 137, the first connection electrode 141, and the second connection electrode 143. Bottom surfaces of the first and second connection electrodes 141 and 143 may be exposed through a bottom surface of the support layer 140.

The support layer 140 may be used as a layer supporting the light-emitting device 100. The support layer 140 may be made of an insulation material. The insulation material may include a resin material such as silicon or epoxy. For another example, the insulation material may include paste or insulation ink. A kind of insulation material may include alone or combinations of a polyacrylate resin, an epoxy resin, a phenolic resin, a polyamides resin, a polyimides resin, an unsaturated polyesters resin, a polyphenylene ether resin (PPE), a polyphenilene oxide resin (PPO), a polyphenylenesulfides resin, a cyanate ester resin, benzocyclobutene (BCB), polyamido-amine dendrimers (PAMAM), polypropylene-imine, Dendrimers (PPI), and PAMAM-OS(organosilicon) having a PAMAM internal structure and an organic-silicon outer surface. The support layer 140 may be made of a material different from that of the insulation layer 133.

At least one of compounds such as oxide, nitride, fluoride, and sulfide, which include at least one of Al, Cr, Si, Ti, Zn, and Zr, may be added to the support layer 140. Here, the compound added to the support layer 140 may serve as a heat dispersing agent. The heat dispersing agent may be used as a powder particle having a predetermined size, a grain, a filler, and an additive. The heat dispersing agent may include a ceramic material. The ceramic material may include at least one of low temperature co-fired ceramic (LTCC), high temperature co-fired ceramic (HTCC), alumina, quartz, calcium zirconate, forsterite, SiC, graphite, fusedsilica, mullite, cordierite, zirconia, beryllia, and aluminum nitride. The ceramic material may include metal nitride, which has heat conductivity greater than that of nitride or oxide, of the insulation material such as nitride or oxide, and the metal oxide may include, for example, a material having heat conductivity of 140 W/mK or more. The ceramic material may be a ceramic-based material, for example, such as SiO₂, SiₓO_{y}, Si₃N₄, SiₓN_{y}, SiOₓN_{y}, Al₂O₃, BN, Si₃N₄, SiC(SiC-BeO), BeO, CeO, and AlN_{.} The heat conductive material may include a component of C (diamond, CNT).

The first and second connection electrodes 141 and 143 of the light-emitting chip are electrically connected to the circuit board.

FIG. 14 is a view illustrating another example of a light-emitting chip that can be used in an embodiment of the invention as defined by the claims.

Referring to FIG. 14, the light-emitting chip includes a light-emitting structure 225 and a plurality of pads 245 and 247. The light emitting structure 225 may be provided as the group II-VI compound semiconductor layer, the group III-V compound semiconductor layer, or the group II-VI compound semiconductor layer. The plurality of pads 245 and 247 may be selectively connected to the semiconductor layer of the light-emitting structure 225 to supply power.

The light-emitting structure 225 may include a first conductive type semiconductor layer 222, an active layer 223, and a second conductive type semiconductor layer 224. The light-emitting chip may include a substrate 221. The substrate 221 may be disposed on the light-emitting structure 225. The substrate 221 may be, for example, a light transmissive or insulation substrate or a conductive substrate. The constituents will be described with reference to the descriptions of the light-emitting structure and the substrate.

Pads 245 and 247 may be disposed on a lower portion of the light-emitting chip, and the pads 245 and 247 may include first and second pads 245 and 247. The first and second pads 245 and 247 are disposed spaced apart from each other under the light-emitting chip. The first pad 245 is electrically connected to the first conductive type semiconductor layer 222, and the second pad 247 is electrically connected to the second conductive type semiconductor layer 224. Each of the first and second pads 245 and 247 may have a bottom shape having a polygonal or circular shape.

The light-emitting chip may include at least one of a buffer layer (not shown) and an undoped semiconductor layer (not shown) between the substrate 221 and the light-emitting structure 225. The buffer layer may be a layer for reducing a lattice constant different between the substrate 221 and the semiconductor layer and may be made of a material selected from the group II-VI compound semiconductors. An undoped group III-V compound semiconductor layer may be further disposed under the buffer layer 112, but is not limited thereto. The substrate 221 may be removed. When the substrate is removed, the phosphor layer 250 may come into contact with a top surface of the first conductive type semiconductor layer 222 or a top surface of the other semiconductor layer.

The light-emitting chip includes first and second electrode layers 241 and 242, a third electrode layer 243, and insulation layers 231 and 233. Each of the first and second electrode layers 241 and 242 may have a single or multilayered structure and function as a current spreading layer. The first and second electrode layers 241 and 242 may include a first electrode layer 241 disposed under the light emitting structure 225 and a second electrode layer 242 disposed under the first electrode layer 241. The first electrode layer 241 may spread current, and the second electrode layer 241 may reflect incident light.

The first and second electrode layers 241 and 242 may be made of materials different from each other. The first electrode layer 241 may be made of a light transmissive material, for example, metal oxide or metal nitride. The first electrode layer may be made of a material selected from indium tin oxide (ITO), ITO nitride (ITON), indium zinc oxide (IZO), IZO nitride (IZON), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), and gallium zinc oxide (GZO). The second electrode layer 242 may come into contact with a bottom surface of the first electrode layer 241 and function as a reflective electrode layer. The second electrode layer 242 may be made of a metal, for example, Ag, Au, or Al. When a portion of a region of the first electrode layer 241 is removed, the second electrode layer 242 may come into partial contact with the bottom surface of the light emitting structure 225.

For another example, the first and second electrode layers 241 and 242 may be laminated with an omni directional reflector layer (ODR) structure. The ODR structure may be a structure in which the first electrode layer 241 having a low refractive index and the second electrode layer 242 coming into contact with the first electrode layer 241 and made of a metal material having high reflectivity are laminated. The electrode layers 241 and 242 may have, for example, a laminated structure of ITO/Ag. A total orientation reflection angle may be improved at an interface between the first electrode layer 241 and the second electrode layer 242.

For another example, the second electrode layer 242 may be removed or provided as a reflective layer made of different material. The reflective layer may have a distributed bragg reflector (DBR) structure. The DBR structure may include a structure in which two dielectric layers having different refractive indexes are alternately disposed, for example, may include one of a SiO₂ layer, a Si₃N₄ layer, a TiO₂ layer, an Al₂O₃ layer, and an MgO layer.

For another example, the electrode layers 241 and 242 may include all of the DBR structure and the ODR structure. In this case, the light-emitting chip having light reflectivity of 98% or more may be provided. Since the light-emitting chip mounted in the flip manner emits light reflected from the second electrode layer 242 through the substrate 221, most of light may be released in a vertical upward direction. Also, light emitted from a side surface of the light-emitting chip may be reflected to an incident surface area of the optical lens by the opening portion of the reflective frame.

The third electrode layer 243 may be disposed under the second electrode layer 242 and electrically insulated from the first and second electrode layers 241 and 242. The third electrode layer 243 may be made of a metal, for example, at least one of Ti, Cu, Ni, Au, Cr, Ta, Pt, Sn, Ag, and P.

The first pad 245 and the second pad 247 are disposed under the third electrode layer 243. The insulation layers 231 and 233 may prevent unnecessary contact between the layers of the first and second electrode layers 241 and 242, the third electrode layer 243, the first and second pads 245 and 247, and the light-emitting structure 225 from occurring. The insulation layers 231 and 233 include first and second insulation layers 231 and 233. The first insulation layer 231 is disposed between the third electrode layer 243 and the second electrode layer 242. The second insulation layer 233 is disposed between the third electrode layer 243 and the first/second pads 245 and 247.

The third conductive layer 243 is connected to the first conductive type semiconductor layer 222. The connection part 244 of the third electrode layer 243 protrudes from a via structure through the first and second electrode layers 241 and 242 and the light emitting structure 225 to come into contact with the first conductive type semiconductor layer 222. The connection part 244 may be provided in plurality. A portion 232 of the first insulation layer 231 extends to the surrounding of the connection part 224 of the third electrode layer 243 to prevent the third insulation layer 243, the first and second electrode layers 241 and 242, the second conductive type semiconductor layer 224, and the active layer 223 from being electrically connected to each other. An insulation layer may be disposed on a side surface of the light emitting structure 225 to protect the side surface, but is not limited thereto.

The second pad 247 is disposed under the second insulation layer 233 and comes into contact with or is connected to at least one of the first and second electrode layers 241 and 242 through an opened region of the second insulation layer 233. The first pad 245 is disposed under the second insulation layer 233 and connected to the third electrode layer 243 through the opened region of the second insulation layer 233. Thus, a protrusion 248 of the first pad 247 is electrically connected to the second conductive type semiconductor layer 224 through the first and second electrode layers 241 and 242, and a protrusion 246 of the second pad 245 is electrically connected to the first conductive type semiconductor layer 222 through the third electrode layer 243.

The first and second pads 245 and 247 may be spaced apart from a lower portion of the light-emitting chip and be electrically connected to the circuit board 10. A bonding member may be disposed between the light-emitting chip and the circuit board. The bonding member may include a solder paste material, for example, at least one of gold (Au), tin (Sn), lead (Pb), copper (Cu), bismuth (Bi), indium (In), and silver (Ag).

For another example, the bonding members may include conductive films. Each of the conductive films includes one or more conductive particles in an insulation film. The conductive particles may be made of, for example, at least one of a metal, a metal alloy, and carbon. The conductive particles may be made of at least one of nickel, silver, gold, aluminum, chrome, copper, and carbon. The conductive film may include an anisotropic conductive film or an anisotropic conductive adhesive.

For another example, the bonding member may include a heat conductive film. The heat conductive film may include a polyester resin such as polyethylene terephthalate, polybutylene terephthalide, polyethylene naphthalate, and polybutylene naphthalate; a polyimide resin; an acrylic resin; a styrene-based resin such as polystyrene and acrylonitrile-styrene; a polycarbonate resin; a polylactic acid resin; and a polyurethane resin. Also, the heat conductive film may be made of a polyolefin resin such as polyethylene, polypropylene and ethylene-propylene copolymer; a vinyl resin such as polyvinyl chloride and polyvinylidene chloride; a polyamide resin; a sulfonic resin; a polyether-ether ketone resin; an allylate-based resin; or blends of the resins.

FIG. 15 is a view illustrating another example of a light-emitting chip that can be used in an embodiment of the invention as defined by the claims.

Referring to FIG. 15, the light-emitting chip may include a light-emitting structure 10 including a plurality of semiconductor layers 11, 12, 13, a first electrode layer 20 under the light-emitting structure 10, a second electrode layer 50 under the first electrode layer 20, an insulation layer 41 between the first and second electrode layers 20 and 50, and a pad 25.

The light-emitting structure 10 may include a first semiconductor layer 11, an active layer 12, and a second semiconductor layer 13. The active layer 12 may be disposed between the first semiconductor layer 11 and the second semiconductor layer 13. The active layer 12 may be disposed under the first semiconductor layer 11, and the second semiconductor layer 13 may be disposed under the active layer 12.

For example, the first semiconductor layer 11 may include an n-type semiconductor layer to which a first conductive type dopant, e.g., an n-type dopant is added, and the second semiconductor layer 13 may include a p-type semiconductor layer to which a second conductive type dopant, e.g., a p-type dopant is added. On the other hand, the first semiconductor layer 11 may be provided as a p-type semiconductor layer, and the second semiconductor layer 13 may be provided as an n-type semiconductor layer.

A rough unevenness 11A may be disposed on a top surface of the first semiconductor layer 11, and the unevenness surface 11A may improve light extraction efficiency. The unevenness surface 11A may have a lateral cross-section with a polygonal shape or a hemispherical shape.

The first electrode layer 20 is disposed between the light-emitting structure and the second electrode layer 50 and electrically connected to the second semiconductor layer 13 of the light-emitting structure 10 and also electrically connected to the second electrode layer 50. The first electrode layer 20 includes a first contact layer 15, a reflective layer 17, and a capping layer 19. The first contact layer 15 is disposed between the reflective layer 17 and the second semiconductor layer 13, and the reflective layer 17 is disposed between the first contact layer 15 and the capping layer 19. The first contact layer 15, the reflective layer 17, and the capping layer 19 may be made of different conductive materials, but is not limited thereto.

The first contact layer 15 may come into contact with the second semiconductor layer, for example, come into ohmic-contact with the second semiconductor layer 13. The first contact layer 15 may be made of, for example, a conductive oxide film, conductive nitride, or a metal. The first contact layer 15 may be made of at least one of indium tin oxide (ITO), ITO nitride (ITON), indium zinc oxide (IZO), IZO nitride (IZON), aluminum zinc oxide (AZO), aluminum gallium zinc oxide (AGZO), indium zinc tin oxide (IZTO), indium aluminum zinc oxide (IAZO), indium gallium zinc oxide (IGZO), indium gallium tin oxide (IGTO), antimony tin oxide (ATO), gallium zinc oxide (GZO), IZO nitride (IZON), ZnO, IrOₓ, RuOₓ, NiO, Pt, Ag, and Ti.

The reflective layer 17 may be electrically connected to the first contact layer 15 and the capping layer 19. The reflective layer 17 may reflect light incident from the light-emitting structure 10 to perform a function for increasing an amount of light extracted to the outside.

The reflective layer 17 may be made of a metal having light reflectivity of 70% or more. For example, the reflective layer 17 may be made of a metal including at least one of Ag, Ni, Al, Rh, Pd, Ir, Ru, Mg, Zn, Pt, Au and Hf or an ally thereof. Also, the reflective layer 17 may be realized as a multi-layer using the above-described metal or an alloy and a light transmissive conductive material such as indium-tin-oxide (ITO), indium-zinc-oxide (IZO), indium-zinc-tin-oxide (IZTO), indium-aluminum-zinc-oxide (IAZO), indium-gallium-zinc-oxide (IGZO), indium-gallium-tin-oxide (IGTO), aluminum-zinc-oxide (AZO), or antimony-tin-oxide (ATO).

For example, the reflective layer 17 according to an embodiment may include at least one of Ag, Al, an Ag-Pd-Cu alloy, or an Ag-Cu alloy. For example, the reflective layer 17 may have a structure in which an Ag layer and an Ni layer are alternately disposed or may include an Ni/Ag/Ni or Ti layer and a Pt layer. For another example, the first contact layer 15 may be disposed under the reflective layer 17, and at least a portion of the first contact layer 15 may pass through the reflective layer 17 to come into contact with the second semiconductor layer 13. For another example, the reflective layer 17 may be disposed under the first contact layer 15, and a portion of the reflective layer 17 may pass through the first contact layer 15 to come into contact with the second semiconductor layer 13.

The light-emitting device according to an embodiment may include a capping layer 19 disposed under the reflective layer 17. The capping layer 19 comes into contact with a bottom surface of the reflective layer 17, and a contact part 34 is coupled to a pad 25 to function as a line layer for transmitting power supplied to the pad 25. The capping layer may be made of a metal, for example, at least one of Au, Cu, Ni, Ti, Ti-W, Cr, W, Pt, V, Fe, and Mo.

The contact part 34 of the capping layer 19 is disposed in a region, which does not vertically overlap the light-emitting structure 10, to vertically overlap the pad 25. The contact part 34 of the capping layer 19 is disposed in a region which does not vertically overlap the first contact layer 15 and the reflective layer 17. The contact part 34 of the capping layer 19 is disposed at a position lower than that of the light-emitting structure 10 to come into direct contact with the pad 25.

The pad 25 may be provided as a single layer or multilayered structure. The single layer may be made of Au, and when the pad 25 is provided as the multilayered structure, the pad 25 may include at least two materials of Ti, Ag, Cu, and Au. Here, in case of the multilayered structure, a laminated structure of Ti/Ag/Cu/Au or a laminated structure of Ti/Cu/Au may be provided. At least one of the reflective layer 17 and the first contact layer 15 may come into direct contact with the pad 25, but is not limited thereto.

The pad 25 may be disposed in a region A1 between an outer wall of the first electrode layer 20 and the light-emitting structure 10. The protection layer 30 and the light transmissive layer 45 may come into contact with a periphery of the pad 25.

The protection layer 30 may be disposed on a bottom surface of the light-emitting structure 10 to come into contact with a bottom surface of the second semiconductor layer 13 and the first contact layer 15 and also come into contact with the reflective layer 17.

An inner portion, which vertically overlaps the light-emitting structure 10, of the protection layer 30 may be disposed to vertically overlap a region of the protrusion 16. An outer portion of the protection layer 30 may extend upward from the contact part 34 of the capping layer 19 and be disposed to vertically overlap the contact part 34. The outer portion of the protection layer 30 may come into contact with the pad 25, for example, be disposed on a circumferential surface of the pad 25.

The inner portion of the protection layer 30 may be disposed between the light-emitting structure 10 and the first electrode layer 20, and the outer portion may be disposed between the light transmissive layer 45 and the contact part 34 of the capping layer 45. The outer portion of the protection layer 30 may extend from a side wall of the light-emitting structure 10 to an external region A1 to prevent moisture from being permeated.

The protection layer 30 may be defined as a channel layer, a low refractive index material layer, or an isolation layer. The protection layer 30 may be made of an insulation material, e.g., oxide or nitride. For example, the protection layer 30 may be made of at least one material selected from the group consisting of SiO₂, SiₓO_{y}, Si₃N₄, SiₓN_{y}, SiOₓN_{y}, Al2O3, TiO₂, and AlN_{.} The protection layer 30 may be made of a transparent material.

The light-emitting device according to an embodiment may include an insulation layer for electrically insulating the first electrode layer 20 from the second electrode layer 50. The insulation layer 41 may be disposed between the first electrode layer 20 and the second electrode layer 50. An upper portion of the insulation layer 41 may come into contact with the protection layer 30. The insulation layer 41 may be made of, for example oxide or nitride. For example, the insulation layer 41 may be made of at least one material selected from the group consisting of SiO₂, SiₓO_{y}, Si₃N₄, SiₓN_{y}, SiOₓN_{y}, Al₂O₃, TiO₂, and AlN.

The insulation layer 41 may have, for example, a thickness of 100 nanometers to 2,000 nanometers. When the insulation layer 41 has a thickness of 100 nanometers or less, insulation characteristics may be deteriorated. When the insulation layer 41 has a thickness exceeding 2,000 nanometers, cracking may occur in the post-process. The insulation layer 41 may come into contact with a bottom surface of the first electrode layer 20 and a top surface of the second electrode layer 50 and thus have a thickness greater than that of each of the protection layer 30, the capping layer 19, the contact layer 15, and the reflective layer 17.

The second electrode layer 50 may include a diffusion barrier layer 52 disposed under the insulation layer 41, a bonding layer 54 disposed under the diffusion barrier layer 52, and a conductive support member 56 disposed under the bonding layer 54 and be electrically connected to the first semiconductor layer 11. Also, the second electrode layer 50 may selectively include one or two of the diffusion barrier layer 52, the bonding layer 54, and the conductive support member 56. At least one of the diffusion barrier layer 52 and the bonding layer 54 may be omitted.

The diffusion barrier layer 52 may be made of at least one of Au, Cu, Ni, Ti, Ti-W, Cr, W, Pt, V, Fe, and Mo. The diffusion barrier layer 52 may function as a diffusion barrier between the insulation layer 41 and the bonding layer 54. The diffusion barrier layer 52 may be electrically connected to the bonding layer 54 and the conductive support member 56 and also electrically connected to the first semiconductor layer 11.

The diffusion barrier layer 52 may perform a function for preventing a material contained in the bonding layer 54 from being diffused in a direction of the reflective layer 17 when the bonding layer 54 is manufactured. The diffusion barrier layer 52 may prevent a material such as tin (Sn) contained in the bonding layer 54 from having an influence on the reflective layer 17.

The bonding layer 54 may be made of a barrier metal or bonding metal, for example, at least one of Ti, Au, Sn, Ni, Cr, Ga, In, Bi, Cu, Ag, Nb, Pd, or Ta. The conductive support member 56 may perform a heat dissipation function by supporting the light-emitting structure 10 according to an embodiment. The bonding layer 54 may include a seed layer.

The conductive support member 56 may be formed by using a metal or a carrier substrate, for example, a semiconductor substrate (e.g., Si, Ge, GaN, GaAs, ZnO, SiC, and SiGe) into which Ti, Cr, Ni, Al, Pt, Au, W, Cu, Mo, Cu-W or an impurity is injected. The conductive support member 56 may be a layer for supporting the light-emitting device 100 and have a thickness corresponding to 80% of a thickness of the second electrode layer 50, i.e., a thickness of 30 *µ*m or more.

The second contact layer 33 is disposed in the first semiconductor layer 11 to come into contact with the first semiconductor layer 11. A top surface of the second contact layer may be disposed at a position higher than a bottom surface of the first semiconductor layer 11, electrically connected to the first semiconductor layer 11, and insulated from the active layer 12 and the second semiconductor layer 13.

The second electrode 33 may be electrically connected to the second conductive layer 50. The second contact layer 33 may be disposed to pass through the first electrode layer 20, the active layer 12, and the second semiconductor layer 15. The second contact layer 33 may be disposed in a recess 2 defined in the light-emitting structure 10 and insulated from the active layer 12 and the second semiconductor layer 15 by the protection layer 30. The second contact layer 33 may be provided in plurality, and the plurality of second contact layers 33 may be spaced apart from each other.

The second contact layer 33 may be connected to a protrusion 51 of the second electrode layer 50, and the protrusion 51 may protrude from the diffusion barrier layer 52. The protrusion 51 may pass through a hole 41A defined in the insulation layer 41 and the protrusion layer 30 and be insulated from the first electrode layer 20.

The second contact layer 33 may be made of at least one of Cr, V, W, Ti, Zn, Ni, Cu, Al, Au, and Mo. For another example, the protrusion 51 may include at least one of the materials forming the diffusion barrier layer 52 and the bonding layer 54, but is not limited thereto. For example, the protrusion 51 may include at least one of Ti, Au, Sn, Ni, Cr, Ga, In, Bi, Cu, Ag, Nb, Pd or Ta.

The pad 25 is electrically connected to the first electrode layer 20 and exposed to the region A1 outside the sidewall of the light-emitting structure 10. The pad 25 may be provided in one or plurality. For example, the pad 25 may be made of at least one of Au, Cu, Ni, Ti, Ti-W, Cr, W, Pt, V, Fe, and Mo.

The light transmissive layer 45 may protect a surface of the light-emitting structure 10, insulate the pad 25 from the light-emitting structure 10, and come into contact with a peripheral portion of the protection layer 30. The light transmissive layer 45 may have a refractive index less than that of the semiconductor layer constituting the light-emitting structure 10 to improve the light extraction efficiency. The light transmissive layer 45 may be made of, for example, oxide or nitride. For example, the light transmissive layer 45 may be made of at least one material selected from the group consisting of SiO₂, SiₓO_{y}, Si₃N₄, SiₓN_{y}, SiOₓN_{y}, Al₂O₃, TiO₂, and AlN. The light transmissive layer 45 may be omitted according to a design. According to an embodiment, the light-emitting structure 10 may be driven by the first electrode layer 20 and the second electrode layer 50.

In the light-emitting device according to an embodiment, the deterioration of the center-side illuminance distribution may be inhabited in the camera module to improve the illuminance distribution in the corner region, particularly, the corner region. Therefore, the entire light uniformity may be improved.

Features, structures, and effects described in the above embodiments are incorporated into at least one embodiment, but are not limited to only one embodiment. Moreover, features, structures, and effects exemplified in one embodiment can easily be combined and modified for another embodiment by those skilled in the art. Therefore, these combinations and modifications should be construed as falling within the scope of the present invention as defined by the claims.

Although embodiments have been described with reference to a number of illustrative embodiments thereof, it should be understood that numerous other modifications and embodiments can be devised by those skilled in the art that will fall within the scope of the invention as defined by the claims. More particularly, various variations and modifications are possible in the component parts and/or arrangements of the subject combination arrangement within the scope of the invention as defined by the appended claims. In addition to variations and modifications in the component parts and/or arrangements, alternative uses will also be apparent to those skilled in the art.

### INDUSTRIAL APPLICABILITY

In the embodiments, the light-emitting device may be improved in illuminance distribution.

In the embodiments, the camera module including the light-emitting device may be improved in light uniformity.

In the embodiments, the light-emitting device and the optical module having the same may be improved in optical reliability.

## Claims

1. A light-emitting device comprising:
a body (410);
a plurality of lead frames (421, 431) on the body (410);
a light-emitting chip (450) disposed on at least one of the plurality of lead frames and electrically connected to the plurality of lead frames; and
a reflective frame (440) having an opening portion for opening an upper portion of the light-emitting chip (450) and disposed on the body (410),
wherein the light-emitting chip (450) comprises a first side surface (S1), a second side surface (S2) adjacent to the first side surface, and a corner region (S3) between the first and second side surfaces (S1,S2),
an inner surface (442) disposed around the opening portion (445) of the reflective frame (440) comprises a first reflective region (S11) adjacent to the first side surface (S1) of the light-emitting chip (450), a second reflective region (S12) adjacent to the second side surface (S2) of the light-emitting chip (450), and a third reflective region (S13) adjacent to the corner region (S3) of the light-emitting chip (450),
wherein the reflective frame (440) is disposed around the light-emitting chip and disposed on the plurality of lead frames,
wherein the inner surface (442) of the opening portion (445) is inclined,
wherein the first to third reflective regions (S11,S12,S13) in the inner surface of the opening portion (445) have an inclination, and the third reflective region (S13) has an inclination greater than that of each of the first and second reflective regions (S11,S12),
wherein the first reflective region (S11) is disposed on a first axis (X) direction, the second reflective region (S12) is disposed on a second axis (Y) direction, and the third reflective region (S13) is disposed on the third axis (W) direction,
and wherein the third axis (W) direction is a diagonal direction having an isogonic angle with respect to the first and second axes (X and Y) between the first and second axes,
**characterized in that** the inner surface (442) of the opening portion (445) gradually increases in inclination approaching the third axis (W), and **in that**
a width (K1) in the first axis (X) direction and a width (K2) in the second axis (Y) direction of a top surface of the opening portion (445) is greater than a width (K3) of the top surface in the third axis (W) direction.

2. The light-emitting device according to claim 1, wherein the first side surface of the light-emitting chip has a length greater than that of the second side surface.

3. The light-emitting device according to claim 1 or 2, wherein the inner surface of the opening portion of the reflective frame has a tilted flat surface or curved surface, and
comprising segments connecting an upper and lower ends of the inner surface of the opening portion and including a first segment (R1) of the first reflective region (S11), a second segment (R2) of the second reflective region (S12), and a third segment (R3) of the third reflective region (S13).

4. The light-emitting device according to any one of claims 1 to 3, wherein a vertical axis with respect to a center of the opening portion is defined as an optical axis (Z), the first axis (X) is perpendicular to the optical axis, the second axis (Y) is perpendicular to the optical axis and the first axis, and the third axis (W) has an isogonic angle with respect to the first and second axes (X, Y),
the first reflective region disposed on the first axis and the second reflective region disposed on the second axis gradually increase in inclination as being adjacent to the third reflective region disposed on the third axis,
wherein a width (K6) of a bottom surface of the opening portion (445) in the third axis (W) direction is greater than a width (K4 or K5) of each of the bottom surfaces of the opening portion (445) in the first and second axes (X and Y).

5. The light-emitting device according to claim 4, wherein a distance between a first outline (A0) of a lower end of the inner surface of the opening portion (445) and a second outline (B0) of an upper end gradually decreases as being adjacent to the third axis,
wherein the first outline (A0) is a line connecting a lower edge of the inner surface of the opening portion (445), and
wherein the second outline (B0) is a line connecting an upper edge of the inner surface of the opening portion (445).

6. The light-emitting device according to claim 5, wherein a distance from the optical axis to a point of the first outline (A0) disposed on the third axis is greater than a distance between points of the first outline (A0), which are disposed on the first and second axes, and the optical axis.

7. The light-emitting device according to claim 6, wherein a distance from the optical axis to a point of the second outline (B0) disposed on the third axis is smaller than a distance between points of the second outline (B0), which are disposed on the first and second axes, and the optical axis.

8. The light-emitting device according to any one of claims 1 to 7, wherein the body includes a hook protrusion (417) disposed on an outer periphery of the body,
wherein reflective frame (440) includes a stopping protrusion (447) disposed on the hook protrusion on an outer periphery of the reflective frame,
wherein guide protrusions (418, 419) are disposed around an upper portion of the body (410) and guide insertion of the reflective frame 440 to prevent the reflective frame (440) from horizontally moving, wherein the guide protrusions (418, 419) are disposed to be spaced apart from each other and include a first guide protrusion (418) and a second guide protrusion (419),
wherein the hook protrusion (417) has a structure that is stepped from each of the guide protrusions (418, 419) of the body (417).

9. The light-emitting device according to any one of claims 1 to 8, wherein the body has a cavity (415) wider than a bottom surface area of the opening portion (445),
wherein the reflective frame is disposed in the cavity, and
wherein a lower end (441) of the inner surface of the opening portion is spaced apart from the plurality of lead frames which is disposed on a bottom surface of the cavity (415),
and wherein the lower end (441) of the opening portion (445) is disposed at a position lower than that of the top surface of the light-emitting chip (450).

10. The light-emitting device according to any one of claims 1 to 9, wherein the body comprises an insulation material,
the reflective frame comprises a metal material having reflectivity greater than that of the body, and
wherein the lower end (441) of a side surface of the opening portion (445) is spaced by a predetermined distance (G1) from the top surface of each of first and second lead frames (421, 431) of the lead frames and spaced in a range of 50 µm to 150 µm.

11. The light-emitting device according to any one of claims 1 to 10, wherein the opening portion of the reflective frame is provided in plurality, and
at least one light-emitting chip is disposed under each of the opening portions.

12. The light-emitting device according to any one of claims 1 to 11, wherein the light-emitting chip is provided in plurality under the opening portion.

13. The light-emitting device according to any one of claims 1 to 12, wherein the light-emitting chip comprises a phosphor layer and an adhesion member between the body and the reflective frame.

14. The light-emitting device according to any one of claims 1 to 13, wherein the reflective frame (440) is disposed on first and second lead frames (421,431) of the plurality of lead frames,
wherein the light-emitting chip (450) is disposed on first and second lead frames (421,431) of the plurality of lead frames,
wherein the reflective frame (440) is disposed to vertically overlap the first and second lead frames (421,431) in a region of a cavity (415) of the body,
wherein the opening portion (445) of the reflective frame (440) has a bottom surface area greater than a top surface area of the light-emitting chip (450) and less than a top surface area of the first lead frame (421) exposed to the cavity (415).

15. A camera module comprising:
a circuit board; and
a light-emitting device disposed on the circuit board,
wherein the light-emitting device comprises the light-emitting device according to any one of claims 1 to 14, and
the camera module further comprises an optical lens disposed on an opening portion of a reflective frame provided in the light-emitting device.

## Patentansprüche

1. Lichtemittierende Vorrichtung, welche aufweist:
einen Körper (410);
eine Mehrzahl von Leiterrahmen (421, 431) auf dem Körper (410);
einen lichtemittierenden Chip (450), der auf zumindest einem der Mehrzahl von Leiterrahmen angeordnet ist und mit der Mehrzahl von Leiterrahmen elektrisch verbunden ist; und
einen reflektierenden Rahmen (440), der einen offenen Abschnitt zum Öffnen eines oberen Abschnitts des lichtemittierenden Chips (450) aufweist und auf dem Körper (410) angeordnet ist,
wobei der lichtemittierende Chip (450) eine erste Seitenfläche (S1), eine der ersten Seitenfläche benachbarte zweite Seitenfläche (S2) sowie einen Eckbereich (S3) zwischen den ersten und zweiten Seitenflächen (S1,S2) aufweist,
wobei eine Innenfläche (442), die um den Öffnungsabschnitt (445) des reflektierenden Rahmens (440) herum angeordnet ist, einen ersten reflektierenden Bereich (S11) benachbart der ersten Seitenfläche (S1) des lichtemittierenden Chips (450), einen zweiten reflektierenden Bereich (S12) benachbart der zweiten Seitenfläche (S2) des lichtemittierenden Chips (450) sowie einen dritten reflektierenden Bereich (S13) benachbart dem Eckbereich (S3) des lichtemittierenden Chips (450) aufweist,
wobei der reflektierende Rahmen (440) um den lichtemittierenden Chip herum angeordnet ist und auf der Mehrzahl von Leiterrahmen angeordnet ist,
wobei die Innenfläche (442) des Öffnungsabschnitts (445) geneigt ist,
wobei die ersten bis dritten reflektierenden Bereiche (S11 ,S12,S13) in der Innenfläche des Öffnungsabschnitts (445) eine Neigung haben, und der dritte reflektierende Bereich (S13) eine größere Neigung hat als jene von jedem der ersten und zweiten reflektierenden Bereiche (S11,S12),
wobei der erste reflektierende Bereich (S11) auf einer ersten Achs- (X)-Richtung angeordnet ist, der zweite reflektierende Bereich (S12) auf einer zweiten Achs- (Y)-Richtung angeordnet ist und der dritte reflektierende Bereich (S13) auf der dritten Achs- (W)-Richtung angeordnet ist, und
wobei die dritte Achs- (W)-Richtung eine diagonale Richtung mit einem isogonen Winkel in Bezug auf die ersten und zweiten Achsen (X und Y) und zwischen den ersten und zweiten Achsen ist,
**dadurch gekennzeichnet, dass** die Neigung der Innenoberfläche (442) des Öffnungsabschnitts (445) in Annäherung an die dritte Achse (W) allmählich zunimmt, und dass
eine Breite (K1) in der ersten Achs- (X)-Richtung und eine Breite (K2) in der zweiten Achs- (Y)-Richtung einer oberen Fläche des Öffnungsabschnitts (445) größer ist als eine Breite (K3) der oberen Fläche in der dritten Achs-(W)-Richtung.

2. Die lichtemittierende Vorrichtung nach Anspruch 1, wobei die erste Seitenfläche des lichtemittierenden Chips eine größere Länge hat als jene der zweiten Seitenfläche.

3. Die lichtemittierende Vorrichtung nach Anspruch 1 oder 2, wobei die Innenfläche des Öffnungsabschnitts des reflektierenden Rahmens eine geneigte flache Oberfläche oder eine gekrümmte Oberfläche hat, und Segmente aufweist, die obere und untere Enden der Innenfläche des Öffnungsabschnitts verbinden und ein erstes Segment (R1) des ersten reflektierenden Bereichs (S11), ein zweites Segment (R2) des zweiten reflektierenden Bereichs (S12) sowie ein drittes Segment (R3) des dritten reflektierenden Bereichs (S13) enthalten.

4. Die lichtemittierende Vorrichtung nach einem der Ansprüche 1 bis 3, wobei eine vertikale Achse in Bezug auf eine Mitte des Öffnungsabschnitts als optische Achse (Z) definiert ist, wobei die erste Achse (X) orthogonal zur optischen Achse ist, die zweite Achse (Y) orthogonal zur optischen Achse und der ersten Achse ist, und die dritte Achse (W) einen isogonen Winkel in Bezug auf die ersten und zweiten Achsen (X, Y) hat, wobei die Neigungen des auf der ersten Achse angeordneten ersten reflektierenden Bereichs und des auf der zweiten Achse angeordneten dritten reflektierenden Bereichs benachbart dem auf der dritten Achse angeordneten dritten reflektierenden Bereich allmählich zunehmen,
wobei eine Breite (K6) einer unteren Fläche des Öffnungsabschnitts (445) in der dritten Achs- (W)-Richtung größer ist als eine Breite (K4 oder K5) jeder der unteren Flächen des Öffnungsabschnitts (445) in den ersten und zweiten Achsen (X und Y).

5. Die lichtemittierende Vorrichtung nach Anspruch 4, wobei ein Abstand zwischen einem ersten Umriss (A0) eines unteren Endes der Innenfläche des Öffnungsabschnitts (445) und einem zweiten Umriss (B0) eines oberen Endes benachbart der dritten Achse allmählich abnimmt,
wobei der erste Umriss (A0) eine Linie ist, die einen unteren Rand der Innenfläche des Öffnungsabschnitts (445) verbindet, und
wobei der zweite Umriss (B0) eine Linie ist, die einen oberen Rand der Innenfläche des Öffnungsabschnitts (445) verbindet.

6. Die lichtemittierende Vorrichtung nach Anspruch 5, wobei ein Abstand von der optischen Achse zu einem auf der dritten Achse angeordneten Punkt des ersten Umrisses (A0) größer ist als ein Abstand zwischen auf den ersten und zweiten Achsen angeordneten Punkten des ersten Umrisses (A0) und der optischen Achse.

7. Die lichtemittierende Vorrichtung nach Anspruch 6, wobei ein Abstand von der optischen Achse zu einem auf der dritten Achse angeordneten Punkt des zweiten Umrisses (B0) kleiner ist als ein Abstand zwischen auf den ersten und zweiten Achsen angeordneten Punkten des zweiten Umrisses (B0) und der optischen Achse.

8. Die lichtemittierende Vorrichtung nach einem der Ansprüche 1 bis 7, wobei der Körper einen Hakenvorsprung (417) enthält, der an einem Außenumfang des Körpers angeordnet ist,
wobei der reflektierende Rahmen (440) einen Stoppvorsprung (447) enthält,
der an dem Hakenvorsprung am Außenumfang des reflektierenden Rahmens angeordnet ist,
wobei Führungsvorsprünge (418, 419) um einen oberen Abschnitt des Körpers (410) herum angeordnet sind und ein Einsetzen des reflektierenden Rahmens 440 führen, um eine horizontale Bewegung des reflektierenden Rahmens (440) zu verhindern, wobei die Führungsvorsprünge (418, 419) mit Abstand voneinander angeordnet sind und einen ersten Führungsvorsprung (418) und einen zweiten Führungsvorsprung (419) enthalten,
wobei der Hakenvorsprung (417) eine Struktur hat, die von jedem der Führungsvorsprünge (418, 419) des Körpers (417) abgestuft ist.

9. Die lichtemittierende Vorrichtung nach einem der Ansprüche 1 bis 8, wobei der Körper einen Hohlraum (415) hat, der weiter ist als eine untere Flächenausdehnung des Öffnungsabschnitts (445),
wobei der reflektierende Rahmen in dem Hohlraum angeordnet ist, und wobei ein unteres Ende (441) der Innenfläche des Öffnungsabschnitts mit Abstand von der Mehrzahl von Leiterrahmen angeordnet ist, die an einer unteren Fläche des Hohlraums (415) angeordnet ist, und
wobei das untere Ende (441) des Öffnungsabschnitts (445) an einer tieferen Position angeordnet ist als jene der oberen Fläche des lichtemittierenden Chips (450).

10. Die lichtemittierende Vorrichtung nach einem der Ansprüche 1 bis 9, wobei der Körper ein Isoliermaterial aufweist,
der reflektierende Rahmen ein Metallmaterial aufweist, dessen Reflektionsvermögen größer ist als jenes des Körpers, und
wobei das untere Ende (441) einer Seitenfläche des Öffnungsabschnitts (445) mit einem vorbestimmten Abstand (G1) im Bereich von 50µm bis 150µm von der oberen Fläche jedes der ersten und zweiten Leiterrahmen (421, 431) der Leiterrahmen angeordnet ist.

11. Die lichtemittierende Vorrichtung nach einem der Ansprüche 1 bis 10, wobei der Öffnungsabschnitt des reflektierenden Rahmens in einer Mehrzahl vorgesehen ist, und
unter jedem der Öffnungsabschnitte zumindest ein lichtemittierender Chip angeordnet ist.

12. Die lichtemittierende Vorrichtung nach einem der Ansprüche 1 bis 11, wobei der lichtemittierende Chip in einer Mehrzahl unter dem Öffnungsabschnitt vorgesehen ist.

13. Die lichtemittierende Vorrichtung nach einem der Ansprüche 1 bis 12, wobei der lichtemittierende Chip eine Phosphorschicht und ein Haftelement zwischen dem Körper und dem reflektierenden Rahmen aufweist.

14. Die lichtemittierende Vorrichtung nach einem der Ansprüche 1 bis 13,
wobei der reflektierende Rahmen (440) auf ersten und zweiten Leiterrahmen (421,431) der Mehrzahl von Leiterrahmen angeordnet ist, wobei der lichtemittierende Chip (450) auf ersten und zweiten Leiterrahmen (421,431) der Mehrzahl von Leiterrahmen angeordnet ist,
wobei der reflektierende Rahmen (440) so angeordnet ist, dass er die ersten und zweiten Leiterrahmen (421,431) in einem Bereich eines Hohlraums (415) des Körpers vertikal überlappt,
wobei der Öffnungsabschnitt (445) des reflektierenden Rahmens (440) eine untere Flächenausdehnung hat, die größer ist als eine obere Flächenausdehnung des lichtemittierenden Chips (450) und kleiner als eine zum Hohlraum (415) freiliegende obere Flächenausdehnung des ersten Leiterrahmens (421).

15. Kameramodul, welches aufweist:
eine Schaltplatine; und
eine lichtemittierende Vorrichtung, die auf der Schaltplatine angeordnet ist,
wobei die lichtemittierende Vorrichtung die lichtemittierende Vorrichtung nach einem der Ansprüche 1 bis 14 aufweist, und
das Kameramodul ferner eine optische Linse aufweist, die auf einem Öffnungsabschnitt eines in der lichtemittierenden Vorrichtung vorgesehenen reflektierenden Rahmens angeordnet ist.

## Revendications

1. Dispositif luminescent comprenant :
un corps (410) ;
une pluralité de grilles de connexion (421, 431) sur le corps (410) ;
une puce luminescente (450) disposée sur au moins une de la pluralité de grilles de connexion et connectée électriquement à la pluralité de grilles de connexion ; et
un cadre réfléchissant (440) ayant une partie d'ouverture pour ouvrir une partie supérieure de la puce luminescente (450) et disposé sur le corps (410),
dans lequel la puce luminescente (450) comprend une première surface latérale (S1), une deuxième surface latérale (S2) adjacente à la première surface latérale, et une région de coin (S3) entre les première et deuxième surfaces latérales (S 1,S2),
une surface intérieure (442) disposée autour de la partie d'ouverture (445) du cadre réfléchissant (440) comprenant une première région réfléchissante (S11) adjacente à la première surface latérale (S1) de la puce luminescente (450), une deuxième région réfléchissante (S12) adjacente à la deuxième surface latérale (S2) de la puce luminescente (450), et une troisième région réfléchissante (S 13) adjacente à la région de coin (S3) de la puce luminescente (450),
dans lequel le cadre réfléchissant (440) est disposé autour de la puce luminescente et disposé sur la pluralité de grilles de connexion,
dans lequel la surface intérieure (442) de la partie d'ouverture (445) est inclinée,
dans lequel les première à troisième régions réfléchissantes (S11,S12,S13) dans la surface intérieure de la partie d'ouverture (445) ont une inclination, et
la troisième région réfléchissante (S13) a une inclination supérieure à celle de chacune des première et deuxième régions réfléchissantes (S11,S12),
dans lequel la première région réfléchissante (S11) est disposée sur une direction de premier axe (X), la deuxième région réfléchissante (S12) est disposée sur une direction de deuxième axe (Y), et la troisième région réfléchissante (S13) est disposée sur la direction de troisième axe (W),
et dans lequel la direction de troisième axe (W) est une direction diagonale ayant un angle isogonique par rapport aux premier et deuxième axes (X et Y) entre les premier et deuxième axes,
**caractérisé en ce que** la surface intérieure (442) de la partie d'ouverture (445) augmente progressivement en inclinaison en s'approchant du troisième axe (W), et **en ce qu'**une largeur (K1) dans la direction de premier axe (X) et une largeur (K2) dans la direction de deuxième axe (Y) d'une surface de haut de la partie d'ouverture (445) est supérieure à une largeur (K3) de la surface de haut dans la direction de troisième axe (W).

2. Dispositif luminescent selon la revendication 1, dans lequel la première surface latérale de la puce luminescente a une longueur supérieure à celle de la deuxième surface latérale.

3. Dispositif luminescent selon la revendication 1 ou 2, dans lequel la surface intérieure de la partie d'ouverture du cadre réfléchissant a une surface plate penchée ou une surface incurvée, et
comprenant des segments connectant des extrémités supérieure et inférieure de la surface intérieure de la partie d'ouverture et comportant un premier segment (R1) de la première région réfléchissante (S11), un deuxième segment (R2) de la deuxième région réfléchissante (S12), et un troisième segment (R3) de la troisième région réfléchissante (S13).

4. Dispositif luminescent selon l'une quelconque des revendications 1 à 3, dans lequel un axe vertical par rapport à un centre de la partie d'ouverture est défini comme un axe optique (Z), le premier axe (X) est perpendiculaire à l'axe optique, le deuxième axe (Y) est perpendiculaire à l'axe optique et au premier axe, et le troisième axe (W) a un angle isogonique par rapport aux premier et deuxième axes (X, Y),
la première région réfléchissante disposée sur le premier axe et la deuxième région réfléchissante disposée sur le deuxième axe augmentent progressivement en inclinaison en étant adjacentes à la troisième région réfléchissante disposée sur le troisième axe,
dans lequel une largeur (K6) d'une surface de fond de la partie d'ouverture (445) dans la direction de troisième axe (W) est supérieure à une largeur (K4 ou K5) de chacune des surfaces de fond de la partie d'ouverture (445) dans les premier et deuxième axes (X et Y).

5. Dispositif luminescent selon la revendication 4, dans lequel une distance entre un premier contour (A0) d'une extrémité inférieure de la surface intérieure de la partie d'ouverture (445) et un deuxième contour (B0) d'une extrémité supérieure diminue progressivement en étant adjacente au troisième axe,
dans lequel le premier contour (A0) est une ligne connectant un bord inférieur de la surface intérieure de la partie d'ouverture (445), et
dans lequel le deuxième contour (B0) est une ligne connectant un bord supérieur de la surface intérieure de la partie d'ouverture (445).

6. Dispositif luminescent selon la revendication 5, dans lequel une distance de l'axe optique à un point du premier contour (A0) disposé sur le troisième axe est supérieure à une distance entre des points du premier contour (A0), qui sont disposés sur les premier et deuxième axes et l'axe optique.

7. Dispositif luminescent selon la revendication 6, dans lequel une distance de l'axe optique à un point du deuxième contour (B0) disposé sur le troisième axe est inférieure à une distance entre des points du deuxième contour (B0), qui sont disposés sur les premier et deuxième axes et l'axe optique.

8. Dispositif luminescent selon l'une quelconque des revendications 1 à 7, dans lequel le corps comporte une saillie en crochet (417) disposée sur une périphérie extérieure du corps,
dans lequel un cadre réfléchissant (440) comporte une saillie d'arrêt (447) disposée sur la saillie en crochet sur une périphérie extérieure du cadre réfléchissant,
dans lequel des saillies de guidage (418, 419) sont disposées autour d'une partie supérieure du corps (410) et guident l'insertion du cadre réfléchissant 440 pour empêcher le cadre réfléchissant (440) de se déplacer horizontalement, dans lequel les saillies de guidage (418, 419) sont disposées pour être espacées l'une de l'autre et comportent une première saillie de guidage (418) et une deuxième saillie de guidage (419),
dans lequel la saillie en crochet (417) a une structure qui est étagée à partir de chacune des saillies de guidage (418, 419) du corps (417).

9. Dispositif luminescent selon l'une quelconque des revendications 1 à 8, dans lequel le corps a une cavité (415) plus large qu'une zone de surface de fond de la partie d'ouverture (445), dans lequel le cadre réfléchissant est disposé dans la cavité, et
dans lequel une extrémité inférieure (441) de la surface intérieure de la partie d'ouverture est espacée de la pluralité de grilles de connexion qui est disposée sur une surface de fond de la cavité (415), et
dans lequel l'extrémité inférieure (441) de la partie d'ouverture (445) est disposée à une position inférieure à celle de la surface de haut de la puce luminescente (450).

10. Dispositif luminescent selon l'une quelconque des revendications 1 à 9, dans lequel le corps comprend un matériau isolant,
le cadre réfléchissant comprend un matériau métallique ayant une réflectivité supérieure à celle du corps, et
dans lequel l'extrémité inférieure (441) d'une surface latérale de la partie d'ouverture (445) est espacée d'une distance prédéterminée (Gl) de la surface de haut de chacune des première et deuxième grilles de connexion (421, 431) des grilles de connexion et espacée dans une plage de 50 µm à 150 µm.

11. Dispositif luminescent selon l'une quelconque des revendications 1 à 10, dans lequel la partie d'ouverture du cadre réfléchissant est prévue en pluralité, et au moins une puce luminescente est disposée sous chacune des parties d'ouverture.

12. Dispositif luminescent selon l'une quelconque des revendications 1 à 11, dans lequel la puce luminescente est prévue en pluralité sous la partie d'ouverture.

13. Dispositif luminescent selon l'une quelconque des revendications 1 à 12, dans lequel la puce luminescente comprend une couche de phosphore et un élément d'adhésion entre le corps et le cadre réfléchissant.

14. Dispositif luminescent selon l'une quelconque des revendications 1 à 13, dans lequel le cadre réfléchissant (440) est disposé sur des première et deuxième grilles de connexion (421,431) de la pluralité de grilles de connexion,
dans lequel la puce luminescente (450) est disposée sur des première et deuxième grilles de connexion (421,431) de la pluralité de grilles de connexion,
dans lequel le cadre réfléchissant (440) est disposé pour chevaucher verticalement les première et deuxième grilles de connexion (421,431) dans une région d'une cavité (415) du corps,
dans lequel la partie d'ouverture (445) du cadre réfléchissant (440) a une zone de surface de fond supérieure à une zone de surface de haut de la puce luminescente (450) et inférieure à une zone de surface de haut de la première grille de connexion (421) exposée à la cavité (415).

15. Module de caméra comprenant :
une carte de circuit imprimé ; et
un dispositif luminescent disposé sur la carte de circuit imprimé,
dans lequel le dispositif luminescent comprend le dispositif luminescent selon l'une quelconque des revendications 1 à 14, et
le module de caméra comprend en outre une lentille optique disposée sur une partie d'ouverture d'un cadre réfléchissant prévu dans le dispositif luminescent.
